(19) Europäisches Patentamt
European Patent Office
Office européen des brevets

(11) **EP 1 807 481 B1**

(12) **EUROPÄISCHE PATENTSCHRIFT**

(45) Veröffentlichungstag und Bekanntmachung des Hinweises auf die Patenterteilung:
**20.06.2018 Patentblatt 2018/25**

(21) Anmeldenummer: **05803307.7**

(22) Anmeldetag: **03.11.2005**

(51) Int Cl.:
***C09K 11/06*** *(2006.01)* ***H01L 51/50*** *(2006.01)*
***H01L 51/00*** *(2006.01)* ***C09B 69/10*** *(2006.01)*

(86) Internationale Anmeldenummer:
**PCT/EP2005/011734**

(87) Internationale Veröffentlichungsnummer:
**WO 2006/048268 (11.05.2006 Gazette 2006/19)**

(54) **ORGANISCHE ELEKTROLUMINESZENZVORRICHTUNG**

ORGANIC ELECTROLUMINESCENT DEVICE

DISPOSITIF ORGANIQUE ÉLECTROLUMINESCENT

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **06.11.2004 EP 04026402**

(43) Veröffentlichungstag der Anmeldung:
**18.07.2007 Patentblatt 2007/29**

(73) Patentinhaber: **Merck Patent GmbH**
**64293 Darmstadt (DE)**

(72) Erfinder:
- **STÖSSEL, Philipp**
  **60487 Frankfurt (DE)**
- **BREUNING, Esther**
  **65527 Niedernhausen (DE)**
- **VESTWEBER, Horst**
  **34630 Gilserberg (DE)**
- **HEIL, Holger**
  **64295 Darmstadt (DE)**

(56) Entgegenhaltungen:
**EP-A- 0 952 200 EP-A- 1 013 740**
**US-A- 5 886 183 US-A- 5 929 239**

- **HU N-X; XIE S; POPOVIC Z; ONG B; HOR A-M: "5,11-Dihydro-5,11-di-1-naphthylindolo[3,2 -b]carbazole: Atropisomerism in a Novel Hole-Transport Molecule for Organic Light-Emitting Diodes" JOURNAL OF THE AMERICAN CHEMICAL SOCIETY, Bd. 121, 1999, Seiten 5097-5098, XP002331514 in der Anmeldung erwähnt**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 1 807 481 B1

Printed by Jouve, 75001 PARIS (FR)

## Beschreibung

In einer Reihe verschiedenartiger Anwendungen, die im weitesten Sinne der Elektronikindustrie zugerechnet werden können, ist der Einsatz organischer Halbleiter als funktionelle Materialien seit geraumer Zeit Realität bzw. wird in naher Zukunft.erwartet. So finden bereits seit etlichen Jahren organische Ladungstransportmaterialien (i. d. R. Lochtransporter auf Triarylaminbasis) Verwendung in Kopiergeräten. Die Entwicklung organischer Transistoren (O-TFTs, O-FETs), organischer integrierter Schaltungen (O-ICs) und organischer Solarzellen (O-SCs) ist im Forschungsstadium schon sehr weit gediehen, so dass eine Markteinführung innerhalb der nächsten Jahre erwartet werden kann. Bei den organischen Elektrolumineszenzvorrichtungen (OLEDs) ist die Markteinführung bereits erfolgt, wie beispielsweise die Autoradios der Firma Pioneer oder eine Digitalkamera der Firma Kodak mit "organischem Display" belegen. Auch bei den polymeren lichtemittierenden Dioden (PLEDs) sind erste Produkte in Form einer kleinen Anzeige in einem Rasierapparat und einem Mobiltelefon der Firma Philips N. V. am Markt erhältlich.

Allerdings zeigen diese Vorrichtungen immer noch erhebliche Probleme, die einer dringenden Verbesserung bedürfen:

1. Die operative Lebensdauer ist insbesondere bei blauer Emission immer noch gering, so dass bis dato nur einfache Anwendungen kommerziell realisiert werden konnten.
2. Es werden teilweise Mischungen isomerer Verbindungen verwendet, die unterschiedliche physikalische Eigenschaften (Glasübergangtemperatur, Glasbildungseigenschaften, Absorption, Photolumineszenz) aufweisen können. Da diese Stereoisomeren teilweise auch bei der Verarbeitungstemperatur unterschiedliche Dampfdrücke aufweisen, ist keine einheitliche, reproduzierbare Herstellung der organischen elektronischen Vorrichtung möglich. Dieser Sachverhalt wurde in der bisherigen Literatur nicht als Problem erkannt, führt jedoch zu nicht reproduzierbaren Ergebnissen und damit zu erheblichen Störungen bei der Herstellung und beim Betrieb der organischen elektronischen Vorrichtungen.
3. Die verwendeten Verbindungen sind teilweise nur schwer in gängigen organischen Lösemitteln löslich, was ihre Reinigung bei der Synthese, aber auch die Reinigung der Anlagen bei der Herstellung der organischen elektronischen Vorrichtungen erschwert.

Hier wäre es deshalb wünschenswert, Verbindungen zur Verfügung zu haben, die die oben genannten Schwachpunkte nicht aufweisen und die verbesserte Eigenschaften in den organischen elektronischen Vorrichtungen zeigen.

Als nächstliegender Stand der Technik kann die Verwendung verschiedener kondensierter Aromaten, wie z. B. Anthracen- oder Pyrenderivate, als Host-Material insbesondere für blau emittierende Elektrolumineszenzvorrichtungen genannt werden.

Als Host-Material gemäß dem Stand der Technik ist beispielsweise 9,10-Bis(2-naphthyl)anthracen (US 5935721) bekannt. Weitere Anthracen-Derivate, die sich als Host-Materialien eignen, sind beispielsweise in WO 01/076323, in WO 01/021729, in WO 04/013073, in WO 04/018588, in WO 03/087023 oder in WO 04/018587 beschrieben. Host-Materialien, basierend auf aryl-substituierten Pyrenen und Chrysenen, werden in WO 04/016575 beschrieben, wobei diese Anmeldung prinzipiell auch entsprechende Anthracen- und Phenanthren-Derivate mit umfasst. Die Verwendung von Anthracen-Derivaten als Lochblockiermaterial ist beispielsweise in US 2004/0161633 beschrieben. Auch in WO 03/095445, in CN 1362464 und in einigen weiteren Anmeldungen und Publikationen werden beispielsweise 9,10-Bis(1-naphthyl)anthracen-Derivate für die Verwendung in OLEDs beschrieben. In keiner der oben genannten Beschreibungen wird jedoch,auf das Problem der Isomerie eingegangen.

Viele der in diesen Beschreibungen aufgeführten Verbindungen zeigen Atropisomerie, also Stereoisomerie, die durch gehinderte Rotation um eine Einfachbindung zustande kommt, wie unten noch ausführlich beschrieben wird. Beispiele dafür sind die Verbindungen EM5, EM12, EM28, EM32, EM33,EM38, EM39 und EM 54 in WO 04/018588 und die Verbindungen AN23, AN24, AN33, AN34, AN35, AN36, AN55 und AN56 in WO 04/018587. In keiner dieser Beschreibungen wird dieses Problem erkannt, sondern die entsprechenden Verbindungen werden immer als planare Moleküle abgebildet, ohne auf die räumliche Struktur einzugehen. Offensichtlich wurden immer die Mischungen der Isomere für die Herstellung der elektronischen Vorrichtungen verwendet. Dadurch können die oben bereits angedeuteten Probleme auftreten: Die isomeren Formen, die in der Mischung vorliegen, können unterschiedliche physikalische Eigenschaften (Glasübergangstemperatur, Morphologie, optische und elektronische Eigenschaften, etc.) aufweisen. Da diese Isomeren teilweise auch bei unterschiedlichen Temperaturen sublimieren, ist damit insbesondere auch keine einheitliche, reproduzierbare Herstellung der organischen elektronischen Vorrichtungen möglich, da je nach Fortschreiten der Sublimation unterschiedliche Anteile der Isomeren angereichert werden. Dies kann, außer zu Unterschieden in den physikalischen Eigenschaften, auch zu unterschiedlicher Filmmorphologie führen; allemal ist die Reproduzierbarkeit der Deviceherstellung eingeschränkt.

Der oben aufgeführte Stand der Technik belegt, dass das Host-Material eine entscheidende Rolle bei den Eigenschaften organischer Elektrolumineszenzvorrichtungen spielt. Analoges gilt für die Materialien in anderen Funktionen bzw. in anderen Schichten und auch für die Materialien in anderen organischen elektronischen Vorrichtungen. Daher sollte es möglich sein, durch weitere Optimierung der Materialien auch die Eigenschaften der organischen elektronischen Vorrichtungen weiter zu verbessern. Es besteht also weiterhin Bedarf an Materialien, insbesondere Host-Materialien für blau emittierende OLEDs, die in organischen elektronischen Vorrichtungen zu guten Effizienzen und gleichzeitig zu hohen Lebensdauern führen und die bei der Herstellung und beim Betrieb der Vorrichtungen zu reproduzierbaren Ergebnissen führen. Es wurde nun überraschend gefunden, dass organische elektronische Vorrichtungen, die atropisomere Verbindungen enthalten, welche zur Bildung von Diastereomeren befähigt sind, und die eines der möglichen Stereoisomere im Überschuss enthalten, deutliche Verbesserungen gegenüber dem Stand der Technik aufweisen. Mit diesen angereicherten bzw. isolierten Materialien ist eine Steigerung der Effizienz und der Lebensdauer in der organischen elektronischen Vorrichtung im Vergleich zur entsprechenden Isomerenmischung möglich. Insbesondere ist aber mit diesen Materialien die besser reproduzierbare Herstellung organischer elektronischer Vorrichtungen möglich, da nicht eine statistische Materialmischung verwendet wird, deren einzelne Komponenten unterschiedliche Sublimationstemperaturen bzw. unterschiedliche weitere physikalische Eigenschaften aufweisen können und deren Zusammensetzung während des Aufdampfprozesses variiert, sondern Materialien, die stark mit einzelnen Isomeren angereichert sind, bzw. isolierte Isomere.

N.-X. Hu et al. (J. Am. Chem. Soc. 1999, 121, 5097) beschreiben das Auftreten von Atropisomerie in N,N-Dinaphth-1-yl-substituiertem Indolocarbazol, welches als Lochtransportmaterial getestet wurde. Dabei entstanden bei der Synthese die beiden Stereoisomere (wovon eines als Racemat vorliegt) in einem Verhältnis von ca. 1 : 1, wie für eine statistische Reaktion zu erwarten ist. Die Isolierung der Einzelkomponenten war den Autoren nicht möglich, jedoch eine Anreicherung eines der beiden Isomere. Es wurde nur die 1 : 1 Isomerenmischung in organischen Elektrolumineszenzvorrichtungen getestet, jedoch nicht die angereicherte Form eines Isomers, so dass hier keine Aussage über die Unterschiede bei Verwendung eines angereicherten Isomers getroffen werden kann. Ohne dies durch experimentelle Ergebnisse zu belegen, behaupten die Autoren, dass die Verwendung dieser 1:1-Isomerenmischung (im Gegensatz zu einem isolierten Isomer) zu Vorteilen führt, da dadurch die Kristallisation verhindert würde und die Verbindungen ein stabiles Glas bilden könnten. Durch diese Publikation wird beim Leser das Vorurteil gebildet, dass gerade die Verwendung von 1:1-Mischungen atropisomerer Substanzen von Vorteil ist gegenüber der Verwendung angereicherter oder isolierter Isomere.

In US 5929239 wird die Verwendung bestimmter enantiomerenreiner Atropisomere in organischen elektronischen Vorrichtungen beschrieben. Da die dort offenbarten Verbindungen nur Enantiomere, jedoch keine Diastereomere bilden können, ist nicht offensichtlich, welchen Vorteil die Verwendung enantionmerenreiner Atropisomere gegenüber dem Racemat zeigt, da Enantiomere bekannterweise die gleichen physikalischen Eigenschaften (außer der Wechselwirkung mit polarisiertem Licht) aufweisen.

In EP 0952200 werden Diphenylanthracen-Derivate offenbart, die gemäß der Beschreibung angeblich in der Lage sind, stabile Atropisomere durch hohe Energiebarrieren der Rotation um die Einfachbindungen zu bilden. Eigene Untersuchungen haben ergeben, dass diese Verbindungen keine bei Raumtemperatur stabilen und isolierbaren Atropisomere bilden können, so dass unklar ist, was in dieser Beschreibung gemeint ist. Selbst wenn diese Verbindungen tatsächlich stabile Atropisomere bilden könnten, ist nicht offenbart, dass die Verwendung einzelner Atropisomere gegenüber der Mischung zu Vorteilen führt.

In US 5886183 werden Naphthalinlactamimide beschrieben, welche in organischen Elektrolumineszenzvorrichtungen verwendet werden können und welche bei geeigneter Substitution Atropisomere bilden können. Bei einer Verbindung wurden auch die Atropisomere isoliert. Jedoch ist nicht offenbart, dass die isolierten Atropisomere in organischen elektronischen Vorrichtungen verwendet wurden und die Verwendung der isolierten Atropisomere gegenüber der Mischung zu besseren Eigenschaften der organischen elektronischen Vorrichtung führt.

Gegenstand der Erfindung sind organische Leuchtdiode (OLED), enthaltend Kathode, Anode und mindestens eine emittierende Schicht, enthaltend mindestens eine organische Verbindung als Hostmaterial, die Atropisomerie aufweist und dadurch zur Bildung von Diastereomeren befähigt ist, dadurch gekennzeichnet, dass die Verbindung, die Atropisomerie aufweist, eine Verbindung gemäß Formel (1) ist

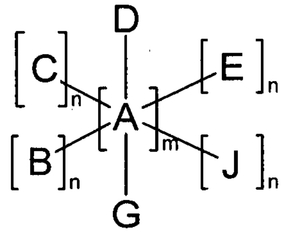

Formel (1)

wobei für die Symbole und Indizes gilt:

A steht für eine 9,10-verknüpfte Anthracen-Einheit, die durch R substituiert oder unsubstituiert sein kann;

B, C, D, E, G, J ist bei jedem Auftreten gleich oder verschieden ein aromatisches oder heteroaromatisches Ringsystem mit 5 bis 40 aromatischen Ringatomen, das unsubstituiert oder durch einen oder mehrere Reste R substituiert sein kann, mit der Maßgabe, dass in mindestens einer ortho-Position zur Verknüpfung zu A eine Gruppe R gebunden ist, bzw. auch dass diese Position durch einen Teil des Ringsystems blockiert ist, wenn B, C, D, E, G bzw. J ein kondensiertes aromatisches Ringsystem darstellen;

R ist bei jedem Auftreten gleich oder verschieden F, Cl, Br, I, eine geradkettige Alkyl- oder Alkoxykette mit 1 bis 40 C-Atomen oder eine verzweigte oder cyclische Alkyl- oder Alkoxykette mit 3 bis 40 C-Atomen, die jeweils durch $R^1$ substituiert sein kann, in der auch ein oder mehrere nicht benachbarte C-Atome durch $N\text{-}R^1$, O, S, C=O, O-CO-O, CO-O, SO, $SO_2$, $P(=O)R^1$, $Si(R^1)_2$, $-CR^1=CR^1-$ oder $-C\equiv C-$ ersetzt sein können und in der auch ein oder mehrere H-Atome durch F, Cl, Br, I oder CN ersetzt sein können, oder ein aromatisches oder heteroaromatisches Ringsystem mit 5 bis 40 aromatischen Ringatomen, welches auch durch einen oder mehrere Reste $R^1$ substituiert sein kann, oder eine Kombination aus zwei, drei, vier oder fünf dieser Systeme; dabei können zwei oder mehrere Reste R miteinander auch ein weiteres mono- oder polycyclisches, aliphatisches oder aromatisches Ringsystem bilden;

$R^1$ ist bei jedem Auftreten gleich oder verschieden H oder ein aliphatischer oder aromatischer Kohlenwasserstoffrest mit 1 bis 20 C-Atomen;

n ist bei jedem Auftreten gleich oder verschieden 0 oder 1;

m ist bei jedem Auftreten gleich oder verschieden 1,2, 3, 4 oder 5, bevorzugt 1, 2 oder 3, besonders bevorzugt 1 oder 2, ganz besonders bevorzugt 1; und

ein Atropisomerenüberschuss von mindestens 70 % vorliegt und dass die Atropisomerie durch gehinderte Rotation um C-C-Einfachbindungen erzeugt wird.

Je nach Struktur der Verbindung, die Atropisomerie aufweist, kann diese in verschiedenen Funktionen in der organischen elektronischen Vorrichtung verwendet werden, so als Host-Material für Dotanden, die aus dem Singulett- oder aus dem Triplett-Zustand Licht emittieren können, als Dotand, als Lochtransportmaterial, als Elektronentransportmaterial oder als Lochblockiermaterial. Dabei unterscheidet sich die Verwendung des Materials mit Atropisomerenüberschuss nicht von der üblichen Verwendung, die mit Isomerenmischungen des jeweiligen Materials bekannt ist. Besonders viele Verbindungen, die Atropisomerie zeigen, sind bislang bei den Host-Materialien für Singulett-Emitter bekannt. Diese sind meist reine Kohlenwasserstoffe bzw. weisen zumindest meist ein reines Kohlenwasserstoff-Grundgerüst auf. In einer bevorzugten Ausführungsform der Erfindung wird daher als Host-Material eine Verbindung verwendet, die Atropisomerie, wie oben beschrieben, zeigt und die einen Atropisomerenüberschuss von mindestens 10 % aufweist. Dies gilt in erster Linie für organische Elektrolumineszenzvorrichtungen. In anderen Vorrichtungen können auch andere Verwendungen der Materialien bevorzugt sein, so beispielsweise Ladungstransportmaterialien in organischen Feld-Effekt-Transistoren oder organischen Dünnfilmtransistoren.

Unter Isomerie wird allgemein die Erscheinung bezeichnet, dass Verbindungen aus der gleichen Anzahl gleicher Atome sich hinsichtlich ihrer Anordnung unterscheiden können. Isomere sind somit chemische Verbindungen mit gleichen Brutto-, jedoch unterschiedlichen Strukturformeln. Für diese Anmeldung ist die Stereoisomerie (unterschiedliche räumliche Anordnung bei gleicher Verknüpfung) von Bedeutung, die im Zusammenhang mit der oben genannten und unten näher ausgeführten Atropisomerie zu Enantiomeren und/oder zu Diastereomeren führen kann.

Als enantiomer werden nach IUPAC-Regel E-4.4 solche Moleküle (Stereoisomere) oder chirale Gruppen bezeichnet, die sich zueinander wie Bild und Spiegelbild verhalten und die nicht miteinander zur Deckung zu bringen sind. Enantiomere unterscheiden sich nicht in ihren physikalischen Eigenschaften, d. h. sie haben den gleichen Dampfdruck, die gleiche Löslichkeit, die gleichen spektroskopischen Daten, usw. Lediglich die chiroptischen Eigenschaften (Wechselwirkung mit polarisiertem Licht) sind unterschiedlich.

Als diastereomer werden nach IUPAC-Regel E-4.6 solche Moleküle (Stereoisomere) bezeichnet, die die gleiche Verknüpfung (Konstitution) aufweisen, sich aber nicht wie Bild und Spiegelbild zueinander verhalten. Diastereomere lassen sich durch keine Symmetrieoperation ineinander überführen und können sowohl chiral als auch achiral sein. Im Gegensatz zu Enantiomeren unterscheiden sich Diastereomere in ihren physikalischen und chemischen Eigenschaften.

Unter Konformation versteht man die genaue räumliche Anordnung von Atomen oder Atomgruppen eines Moleküls definierter Verknüpfung. Verschiedene Konformere werden durch Rotation um Einfachbindungen erzeugt und lassen sich nicht zur Deckung bringen. Entsprechen die so erzeugten Anordnungen einem Energieminimum, so redet man von Konformationsisomeren oder Konformeren.

Unter Atropisomerie (Definition gemäß Römpp Lexikon Chemie - Version 2.0, Stuttgart/New York: Georg Thieme Verlag 1999) wird eine Form der Stereoisomerie verstanden, bei der die Stereoisomerie des Moleküls durch Behinderung der freien Rotation um eine Einfachbindung, also durch sterische Hinderung von Molekülteilen, hervorgerufen wird (also formal Konformere mit gehinderter Rotation). Je nach Anzahl der Einfachbindungen, um die die Rotation gehindert ist, und je nach vorhandenen Substituenten können die Verbindungen chiral oder achiral sein, bzw. sie sind diastereomer zueinander. Bei Atropisomeren stellt sich in der Regel ein Gleichgewicht ein, wenn durch Temperaturerhöhung die innere Beweglichkeit im Molekül vergrößert wird, so dass die Energiebarriere für die gegenseitige Umwandlung überwunden wird. Dagegen wird bei Raumtemperatur, wenn die Energiebarriere ausreichend groß ist, keine Umwandlung der Isomere beobachtet. Isolierbar gelten im Allgemeinen Atropisomere, wenn die Energiebarriere bei Raumtemperatur bei etwa 80 kJ/mol oder mehr liegt, wie beispielsweise bei Biphenyl-Derivaten mit ausreichend großen Substituenten in 2-Position (ortho-Stellung). Da jede stereogene Achse (rotationsgehinderte Einfachbindung) in atropisomeren Verbindungen in der einen oder der anderen von zwei möglichen Konformationen auftreten kann, gibt es $2^n$ Stereoisomere (Diastereomere und Enantiomere) für n nichtäquivalente Achsen. Die Anzahl der Stereoisomere kann jedoch auch weniger als $2^n$ betragen, wenn durch intrinsische Symmetrieelemente z. B. ein Stereoisomer achiral ist oder eine Achse seine Stereogenität verliert, d. h. dass bei Rotation um diese Achse kein neues Stereoisomer gebildet wird.

Die oben gemachten Ausführungen zur Symmetrie haben auf die in dieser Erfindung relevante Atropisomerie verschiedene Auswirkungen:
Wenn Atropisomerie um nur eine Einfachbindung vorliegt, so können je nach Substitution gegebenenfalls Enantiomere, jedoch keine Diastereomere auftreten. Diese haben, wie oben ausgeführt, identische physikalische Eigenschaften, wodurch die Verwendung eines isolierten Enantiomers keine Vorteile bietet. Enantiomere sind außerdem häufig schwierig zu trennen. Daher betrifft diese Erfindung nur Verbindungen mit zwei oder mehr rotationsgehinderten Einfachbindungen, die zur Bildung von Diastereomeren befähigt sind, wobei der Molekülteil zwischen den beiden rotationsgehinderten Einfachbindungen keine weiteren Einfachbindungen aufweist, um die eine freie Rotation möglich ist.

Wenn zwei rotationsgehinderte Einfachbindungen vorliegen, können je nach Aufbau und Substitutionsmuster der einzelnen Molekülteile zwischen 1 und 4 Isomere vorliegen. Dies sei schematisch an einem Molekül des allgemeinen Aufbaus A-B-C dargestellt (Schema 1): Wenn die Molekülteile A und C jeweils gleich und symmetrisch aufgebaut sind, ist auch bei gehinderter Rotation um die Bindungen nur ein einziges Isomer möglich (Schema 1a), da sich die Konformationen nicht unterscheiden und alle Konformere miteinander zur Deckung zu bringen sind. Dies gilt auch, wenn beispielsweise nur der Molekülteil B oder nur einer der Molekülteile A oder C substituiert sind. Sind dagegen die beiden Molekülteile A und C substituiert bzw. unsymmetrisch aufgebaut, wobei A und C gleich oder verschieden sein können, so ergeben sich zwei Atropisomere, die zueinander diastereomer sind (Schema 1b). Diese beiden Atropisomere werden auch als syn- und anti-Form bezeichnet. Jedes dieser beiden Atropisomere ist achiral (also deckungsgleich zu seinem Spiegelbild), da jedes mindestens eine Spiegelebene im Molekül aufweist. Sind nun zusätzlich zu gleichen Substituenten an A und C noch ein oder mehrere Substituenten an B vorhanden, die die Einheit B unsymmetrisch machen, so existiert weiterhin nur eine syn-Form, während die anti-Form in zwei Enantiomere zerfällt (Schema 1c). Sind statt gleicher Substituenten an A und C unterschiedliche Substituenten vorhanden, so entstehen vier Atropisomere, die zueinander diastereomer bzw. enantiomer sind (Schema 1d). In diesem Fall zerfällt sowohl die syn-Form, wie auch die anti-Form in jeweils zwei Enantiomere, wobei jede der beiden syn-Formen zu jeder der beiden anti-Formen diastereomer ist.

Vergleichbare Überlegungen lassen sich anstellen, wenn mehr als zwei Einfachbindungen mit gehinderter Rotation vorhanden sind, wodurch entsprechend mehr Atropisomere entstehen können. Ähnliche Ausführungen können auch der Literatur entnommen werden (bspw. J. Gawronski, K. Kacprzak, Chirality 2002, 14, 689). Die genauen Punktgruppen der entsprechenden Verbindungen hängen von der exakten Geometrie der Moleküle ab. So sind die in Schema 1 angegebenen Punktgruppen nur für die dort abgebildeten schematischen Zeichnungen zu verstehen. Genauere Überlegungen dazu finden sich ebenfalls in der oben zitierten Literatur.

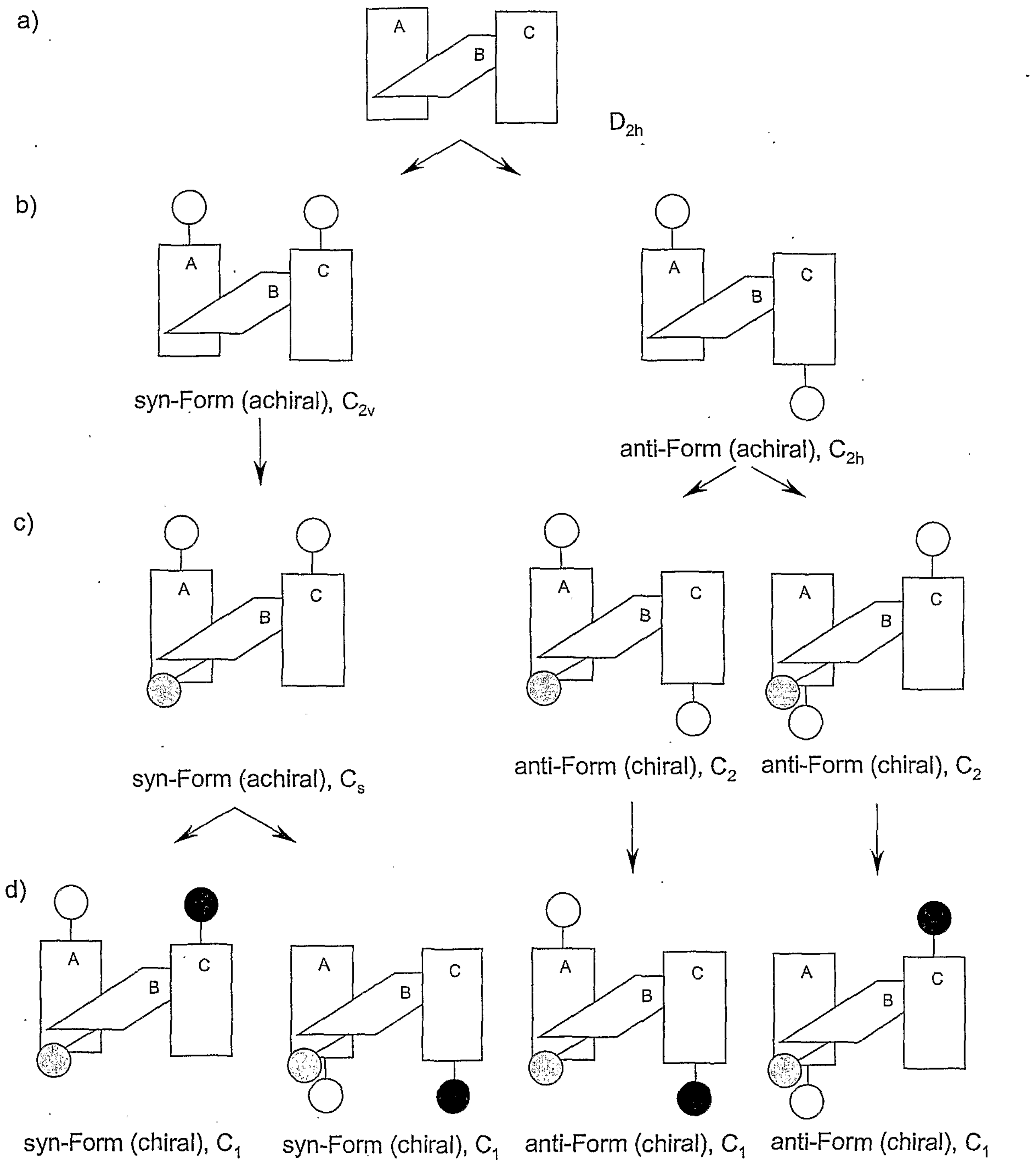


**Schema 1:** Schematische Darstellung der verschiedenen möglichen Atropisomere, abhängig von der Substitution des Moleküls; dabei liegt zwischen den Molekülteilen A, B und C jeweils eine Einfachbindung mit gehinderter Rotation vor.

Die Definition des Atropisomerenüberschuss erfolgt in Analogie zu der in der organischen Chemie gebräuchlichen Definition des Enantiomeren- bzw. Diastereomeren-Überschuss. Unter Atropisomerenüberschuss im Sinne dieser Erfindung soll verstanden werden:

$$\text{Atropisomerenüberschuss [\%]} = [\text{molarer Anteil (Überschuss-Isomer)} - \text{molarer Anteil (Unterschuss-Isomer)}] \times 100$$

Dies bedeutet, dass ein Atropisomerenüberschuss von 10 % einer Verteilung (bei zwei Isomeren) von 55 : 45 entspricht. Einige weitere Atropisomerenüberschüsse und die entsprechenden molaren Verteilungen sind in Tabelle 1 angegeben:

**Tabelle 1:** Zusammenhang zwischen Atropisomerenüberschuss und molarer Verteilung der Isomere.

| Atropisomerenüberschuss | molare Verteilung |
|---|---|
| 10 % | 55 : 45 |
| 20 % | 60 : 40 |
| 50 % | 75 : 25 |
| 90 % | 95 : 5 |
| 95 % | 97.5 : 2.5 |
| 99 % | 99.5 : 0.5 |

Ein Spezialfall kann sich ergeben, wenn mehr als zwei Atropisomere möglich sind, beispielsweise durch Bildung von Enantiomeren, wie in Schema 1c oder 1d beschrieben, oder auch, wenn durch Vorliegen von mehr als zwei Einfachbindungen mit gehinderter Rotation mehr als zwei Diastereomere vorliegen können. In diesen Fällen soll der Atropisomerenüberschuss im Sinne dieser Erfindung folgendermaßen definiert sein:

Bei Vorliegen von Diastereomeren und Enantiomeren (wie in Schema 1c und 1d) soll als Atropisomerenüberschuss der entsprechende Diastereomerenüberschuss (und nicht der Enantiomerenüberschuss) bezeichnet werden, unabhängig davon, ob das Diastereomer noch in Enantiomere zerfällt oder nicht. Dabei ist es gleichermaßen zulässig, dass das angereicherte Diastereomer als Racemat (also beide Enantiomere zu gleichen Anteilen) vorliegt oder dass ein Enantiomer im Überschuss bzw. in Reinform vorliegt.
Bei Vorliegen von mehr als zwei Diastereomeren soll der Atropisomerenüberschuss analog zu oben bestimmt werden, wobei alle Unterschuss-Atropisomere gemeinsam als eine Gruppe betrachtet werden sollen. Hier berechnet sich der Atropisomerenüberschuss also folgendermaßen:

$$\text{Atropisomerenüberschuss [\%]} = [\text{molarer Anteil (Überschuss-Isomer)} - \Sigma\,(\text{molarer Anteil (Unterschuss-Isomere)}) / \text{Anzahl (Unterschuss-Isomere)}] \times 100$$

Der Atropisomerenüberschuss kann mit üblichen chemischen Analysemethoden bestimmt werden, beispielsweise durch HPLC oder durch $^1$H-NMR-Spektroskopie, da es sich um Diastereomere mit unterschiedlichen physikalischen Eigenschaften (unterschiedliche Retentionszeiten in der HPLC, unterschiedliche chemische Verschiebung im NMR) handelt. Eine bevorzugte Methode ist die Bestimmung des Atropisomerenüberschuss durch HPLC.

Um stabile Atropisomere isolieren zu können, muss die Aktivierungsenergie für die Rotation um die entsprechenden Einfachbindungen mindestens ca. 80 kJ/mol betragen. Die oben verwendete Bezeichnung "Einfachbindung mit gehinderter Rotation" soll sich also auf eine Aktivierungsenergie der Rotation um diese Einfachbindung von mindestens 80 kJ/mol beziehen. Diese Aktivierungsenergie lässt sich beispielsweise durch Temperatur-abhängige NMR-Messung bestimmen. Da die Verbindungen jedoch auch höhere Temperaturen aushalten müssen (beispielsweise bei einer Umkristallisation bzw. Sublimation, aber auch in der organischen elektronischen Vorrichtung), ist es bevorzugt, wenn die Aktivierungsenergie für die Rotation um die Einfachbindungen mindestens 100 kJ/mol beträgt, besonders bevorzugt mindestens 120 kJ/mol, insbesondere mindestens 140 kJ/mol. Die Aktivierungsenergie für die Rotation um die Einfachbindung lässt sich durch den genauen Aufbau der Verbindungen und insbesondere durch die Substitution steuern. Die Aktivierungsenergie für die Rotation um die Einfachbindung lässt sich experimentell durch temperaturabhängige NMR-Messungen bestimmen und kann weiterhin auch durch HPLC- bzw. GC-Messungen bei erhöhter Temperatur bestimmt werden.

Es ist bevorzugt, wenn die Atropisomerie zwischen zwei $sp^2$-Zentren erzeugt wird und nicht beispielsweise zwischen einem $sp^2$- und einem $sp^3$-Zentrum. Ebenso ist es bevorzugt, wenn die Atropisomerie durch gehinderte Rotation um C-C-Einfachbindungen erzeugt wird und nicht beispielsweise durch gehinderte Rotation um C-N-Einfachbindungen. Diese Bevorzugung lässt sich dadurch begründen, dass die meisten als Hostmaterialien verwendeten Verbindungen reine Kohlenwasserstoffe sind bzw. zumindest ein reines Kohlenwasserstoff-Grundgerüst aufweisen und daher, falls sie Atropisomerie aufweisen, diese um C-C-Bindungen aufweisen.

Wie oben beschrieben, ist Gegenstand der Erfindung die Verwendung eines Atropisomerenüberschuss von mindestens 70 %, insbesondere mindestens 90 %, mindestens 95 % bzw. mindestens 99 %. Größere Atropisomerenüberschüsse sind bevorzugt, da dadurch eine bessere Reproduzierbarkeit gewährleistet ist.

In einem bevorzugten Aspekt der vorliegenden Erfindung weist die Verbindung genau zwei Einfachbindungen mit gehinderter Rotation auf, und das überwiegend vorliegende Atropisomer ist das syn-Isomer.

In einem weiteren bevorzugten Aspekt der vorliegenden Erfindung weist die Verbindung genau zwei Einfachbindungen mit gehinderter Rotation auf, und das überwiegend vorliegende Atropisomer ist das anti-Isomer.

In nochmals einem weiteren bevorzugten Aspekt der vorliegenden Erfindung werden Verbindungen verwendet, die genau drei Einfachbindungen mit gehinderter Rotation aufweisen und daher mehr als die in Schema 1 aufgeführten vier Atropisomere aufweisen können. Dabei können diese Einfachbindungen, um die Atropisomerie vorliegt, entweder linear oder verzweigt angeordnet sein.

In nochmals einem weiteren bevorzugten Aspekt der vorliegenden Erfindung werden Verbindungen verwendet, die genau vier Einfachbindungen mit gehinderter Rotation aufweisen und daher nochmals mehr Atropisomere aufweisen können. Dabei können diese Einfachbindungen, um die Atropisomerie vorliegt, entweder linear oder verzweigt angeordnet sein.

In nochmals einem weiteren bevorzugten Aspekt der vorliegenden Erfindung werden Verbindungen verwendet, die mehr als vier Einfachbindungen mit gehinderter Rotation aufweisen und daher nochmals mehr Atropisomere aufweisen können. Dabei können diese Einfachbindungen, um die Atropisomerie vorliegt, entweder linear oder verzweigt angeordnet sein.

Im Rahmen der vorliegenden Erfindung werden unter einer $C_1$- bis $C_{40}$-Alkylgruppe, in der auch einzelne H-Atome oder $CH_2$-Gruppen durch die oben genannten Gruppen substituiert sein können, besonders bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, n-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl oder Octinyl verstanden. Unter einer $C_1$- bis $C_{40}$-Alkoxygruppe werden besonders bevorzugt Methoxy, Ethoxy, n-Propoxy, i-Propoxy, n-Butoxy, i-Butoxy, s-Butoxy, t-Butoxy oder 2-Methylbutoxy verstanden. Unter einem aromatischen oder heteroaromatischen Ringsystem mit 5 - 40 aromatischen Ringatomen, welches noch jeweils mit den oben genannten Resten R substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Phenanthren, Pyren, Chrysen, Perylen, Fluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, Truxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzö-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

In einer bevorzugten Ausführungsform der Erfindung ist an A in allen ortho-Positionen zur Verknüpfung zu B, C, D, E, G und J mindestens ein Kohlenstoffatom gebunden. Dieses kann entweder Teil eines kondensierten Ringsystems (direkt an der aromatischen bzw. heteroaromatischen Einheit A) sein, oder es kann als Substituent R an A gebunden sein.
In einer weiteren bevorzugten Ausführungsform der Erfindung ist an B, C, D, E, G und J in jeweils mindestens einer ortho-Position zur Verknüpfung zu A mindestens ein Kohlenstoffatom gebunden. Dieses kann entweder Teil eines kondensierten Ringsystems (direkt in der aromatischen bzw. heteroaromatischen Einheit B, C, D, E, G bzw. J) sein, oder es kann als Substituent R jeweils an B, C, D, E, G bzw. J gebunden sein.
Insbesondere bevorzugt sind die noch stabileren Atropisomere, die erhalten werden können, wenn in ortho-Position zur jeweiligen Verknüpfung größere Gruppen vorhanden sind, bevorzugt mit mindestens zwei C-Atomen, die Teil eines kondensierten Ringsystems oder eines Substituenten R sein können.

In einer bevorzugten Ausführungsform sind D und G (und gegebenenfalls auch B, C, E und/oder J) kondensierte aromatische Ringsysteme oder ortho-Biphenyl. In einer besonders bevorzugten Ausführungsform der Erfindung sind A und D und G (und wenn vorhanden auch B, C, E und J) jeweils kondensierte aromatische Ringsysteme. In einer weiteren bevorzugten Ausführungsform der Erfindung ist mindestens eine der Gruppen A, D und/oder G (und/oder gegebenenfalls B, C, E und/oder J) ein kondensiertes heteroaromatisches Ringsystem, und die Gruppen D und/oder G (und/oder gegebenenfalls B, C, E und/oder J) stellen ein ortho-Biphenyl-System dar.

Eine Arylgruppe im Sinne dieser Erfindung enthält 6 bis 40 C-Atome; eine Heteroarylgruppe im Sinne dieser Erfindung enthält 2 bis 40 C-Atome und mindestens 1 Heteroatom, mit der Maßgabe, dass die Summe aus C-Atomen

und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe im Sinne der unten folgenden Definition verstanden. Dagegen ist beispielsweise Biphenyl, bei dem eine frei rotierbare C-C-Bindung zwischen den beiden Phenyleinheiten vorliegt, keine Arylgruppe im Sinne dieser Erfindung.

Unter einem aromatischen oder heteroaromatischen Ringsystem im Sinne dieser Erfindung soll ein System verstanden werden, das nicht notwendigerweise nur aromatische bzw. heteroaromatische Gruppen enthält, sondern in dem auch mehrere aromatische oder heteroaromatische Gruppen durch eine kurze, nicht aromatische Einheit (weniger als 10 % der von H verschiedenen Atome, bevorzugt weniger als 5 % der von H verschiedenen Atome), wie z. B. ein $sp^3$-hybridisiertes C-, N- oder O-Atom, unterbrochen sein können. So sollen also beispielsweise auch Systeme wie 9,9'-Spirobifluoren, 9,9-Diarylfluoren, Triarylamin, etc. als aromatische Ringsysteme im Sinne dieser Erfindung verstanden werden. Dabei kann das aromatische oder heteroaromatische Ringsystem auch ein kondensiertes System im Sinne der folgenden Definition sein.

Unter kondensierten aromatischen bzw. heteroaromatischen Ringsystemen im Sinne dieser Erfindung werden Ringsysteme verstanden, in denen mindestens zwei Ringe, von denen mindestens einer aromatisch oder heteroaromatisch ist, miteinander "verschmolzen", d. h. durch Anellierung einander ankondensiert sind, also mindestens eine gemeinsame Kante und ein gemeinsames aromatisches $\pi$-Elektronensystem aufweisen. Diese Ringsysteme können durch R substituiert oder unsubstituiert sein. So sind beispielsweise Systeme wie Naphthalin, Tetrahydronaphthalin, Anthracen, Phenanthren, Pyren, Carbazol, etc. als kondensierte aromatische Ringsysteme zu sehen, während beispielsweise Biphenyl kein kondensiertes aromatisches Ringsystem darstellt, da dort keine gemeinsame Kante zwischen den beiden Ringsystemen vorliegt.

Bevorzugt enthalten die kondensierten aromatischen Ringsysteme zwischen zwei und acht aromatische und/oder heteroaromatische Einheiten, die jeweils über eine oder mehrere gemeinsame Kanten einander ankondensiert sind und dadurch ein gemeinsames aromatisches System ausbilden und die durch R substituiert oder unsubstituiert sein können.

Besonders bevorzugt enthalten die kondensierten aromatischen Ringsysteme zwischen zwei und sechs heteroaromatische oder bevorzugt aromatische Einheiten, insbesondere zwei, drei oder vier aromatische Einheiten, die jeweils über eine oder mehrere gemeinsame Kanten einander ankondensiert sind und dadurch ein gemeinsames aromatisches System ausbilden und die durch R substituiert oder unsubstituiert sein können.

Ganz besonders bevorzugt sind die einander ankondensierten aromatischen und heteroaromatischen Einheiten ausgewählt aus Benzol, Pyridin, Pyrimidin, Pyrazin, Pyridazin, Pyrrol, Furan und Thiophen, die durch R substituiert oder unsubstituiert sein können, insbesondere Benzol und Pyridin:

Die kondensierten aromatischen Ringsysteme sind bevorzugt ausgewählt aus der Gruppe bestehend aus Naphthalin, Anthracen, Phenanthren, Pyren, Naphthacen, Chrysen, Pentacen, Chinolin, Isochinolin, Chinoxalin, Phenanthrolin, Perylen, Triphenylen, Carbazol, Benzothiophen oder Dibenzothiophen, die gegebenenfalls durch R substituiert sein können. Besonders bevorzugt sind die kondensierten aromatischen Ringsysteme ausgewählt aus der Gruppe bestehend aus Naphthalin, Anthracen, Phenanthren, Pyren oder Perylen, die gegebenenfalls durch R substituiert sein können, insbesondere Naphthalin, Anthracen, Phenanthren und Pyren. Die Substitution mit R kann insbesondere sinnvoll sein, um die Aktivierungsenergie für die Rotation um die entsprechende Einfachbindung zu erhöhen und somit stabilere Isomere zu erhalten. Die Substitution kann weiterhin sinnvoll sein, um besser lösliche Verbindungen zu erhalten. Insbesondere kann die Substitution auch helfen, zwischen unterschiedlichen Atropisomeren zu differenzieren, da sich je nach Verbindung durch den Substituenten die Eigenschaften der beiden Isomere, beispielsweise die Löslichkeit und/oder die Polarität, zu unterschiedlichen Anteilen ändert, wodurch die Auftrennung der beiden Isomere vereinfacht werden kann.

Das Symbol A steht für eine 9,10-verknüpfte Anthracen-Einheit. Diese weist durch die Art der Verknüpfung bereits ausreichend große Gruppen in ortho-Position zur Verknüpfung auf, so dass hier keine weiteren Substituenten an dieser Einheit zwingend nötig sind, um stabile Atropisomere zu ermöglichen.

Beispiele für geeignete Verbindungen, die Atropisomere bilden, sind die unten abgebildeten Strukturen 1 bis 17, wobei jeweils das Beispiel a die syn-Form und das Beispiel b die anti-Form zeigt und wobei sich jeweils beide (bzw. alle) möglichen Atropisomere in angereichter bzw. bevorzugt reiner Form für die Verwendung in organischen elektronischen Vorrichtungen eignen. Dabei deuten die dick abgebildeten Bindungen die Molekülteile an, die oberhalb der Ebene liegen, die durch die zentrale Einheit aufgespannt wird.

| | |
|---|---|
| 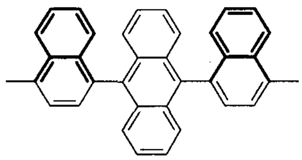 | 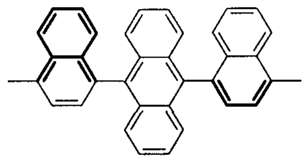 |
| Struktur 1a (syn) | Struktur 1b (anti) |
| 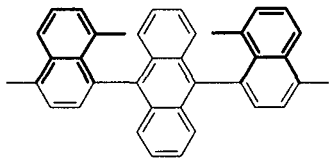 | 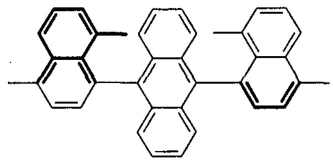 |
| Struktur 2a (syn) | Struktur 2b (anti) |
| 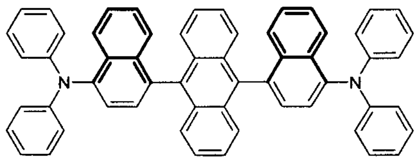 | 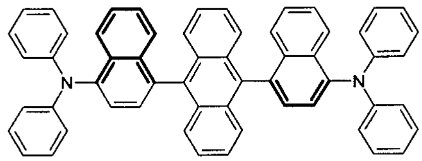 |
| Struktur 3a (syn) | Struktur 3b (anti) |
| 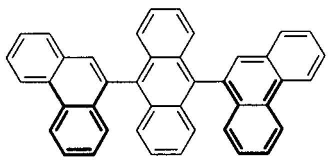 | 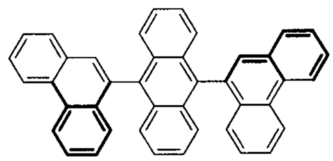 |
| Struktur 4a (syn) | Struktur 4b (anti) |
| 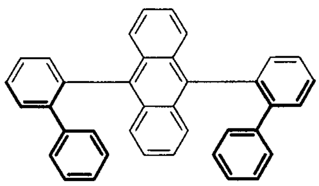 | 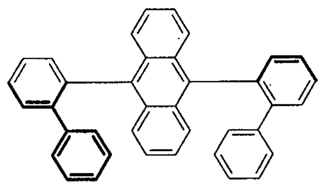 |
| Struktur 5a (syn) | Struktur 5b (anti) |
| 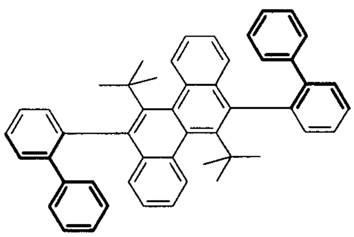 | 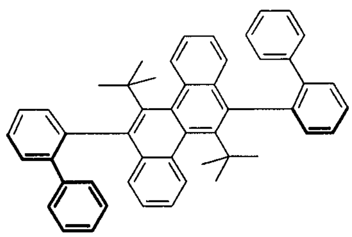 |
| Struktur 6a (syn)* | Struktur 6b (anti)* |
| 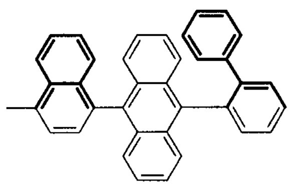 | 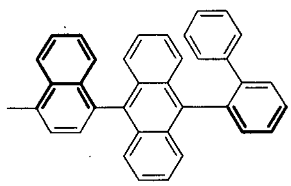 |
| Struktur 7a (syn) | Struktur 7b (anti) |

(fortgesetzt)

| | |
|---|---|
| 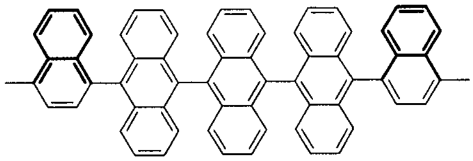 | 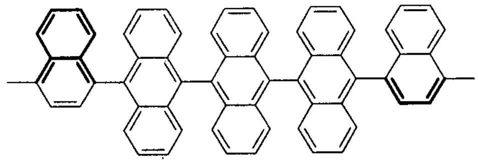 |
| Struktur 8a (syn) | Struktur 8b (anti) |
| 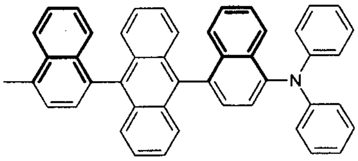 | 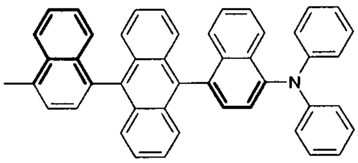 |
| Struktur 9a (syn) | Struktur 9b (anti) |
| 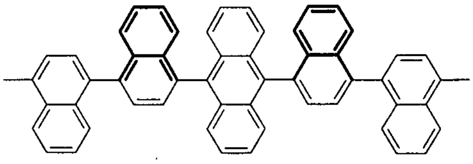 | 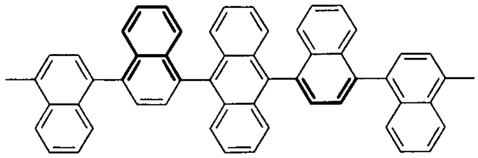 |
| Struktur 10a (syn) | Struktur 10b (anti) |
| 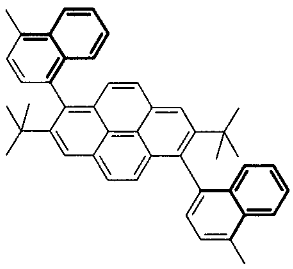 | 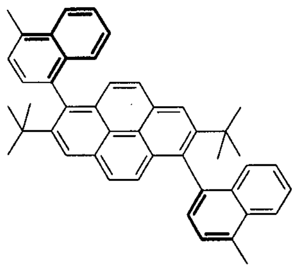 |
| Struktur 11a (syn)* | Struktur 11b (anti)* |
| 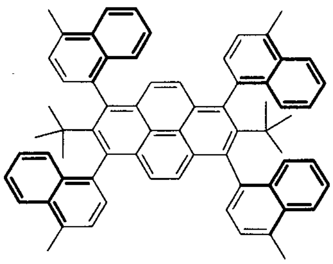 | 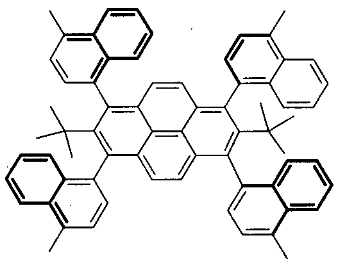 |
| Struktur 12a (syn-syn-syn)* | Struktur 12b (anti-anti-anti)* |
| 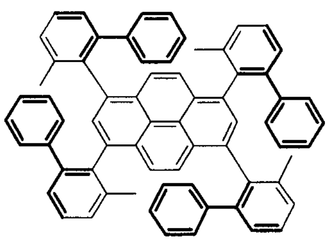 | 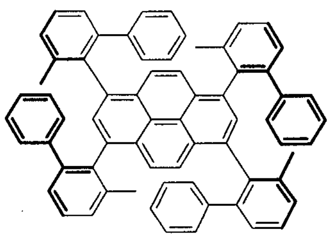 |
| Struktur 13a (syn-syn-syn)* | Struktur 13b (anti-anti-anti)* |

(fortgesetzt)

| | |
|---|---|
| 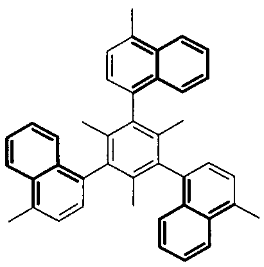 | 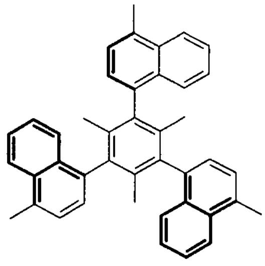 |
| Struktur 14a (syn-syn)* | Struktur 14b (syn-anti)* |
| 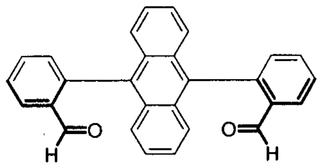 | 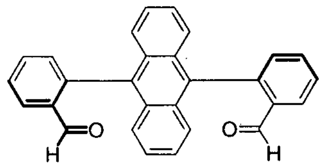 |
| Struktur 15a (syn-syn)* | Struktur 15b (syn-anti)* |
| 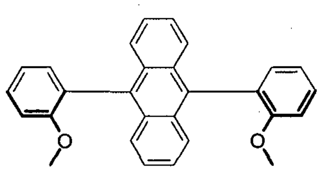 | 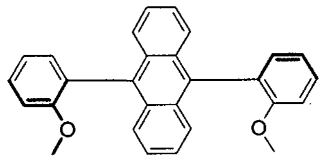 |
| Struktur 16a (syn) | Struktur 16b (anti) |
| 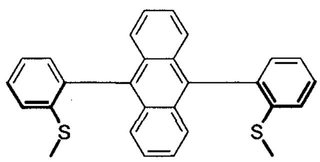 | 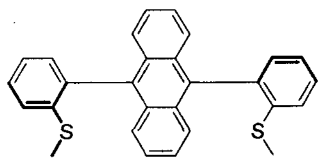 |
| Struktur 17a (syn) | Struktur 17b (anti) |
| * Nicht erfindungsmäßig | |

Weitere bevorzugte Verbindungen, die Atropisomerie um C-C-Bindungen aufweisen und zur Bildung von Diastereomeren befähigt sind, sind beliebige der unten abgebildeten Struktureinheiten (A4) bis (A9), die mit beliebigen der Struktureinheiten (D1) bis (D12) und (G1) bis (G12) kombiniert werden. Dabei bedeutet die gestrichelte Bindung jeweils die Anknüpfung an die anderen Einheiten gemäß Formel (1).
Die Reste $R_a$ an den Einheiten (A4) bis (A9) werden bevorzugt gewählt aus der Gruppe bestehend aus Methyl, *tert*-Butyl, Fluor, Phenyl, *ortho*-Tolyl, *meta*-Tolyl, *para*-Tolyl, *ortho*-Fluorphenyl, *meta*-Fluorphenyl, *para*-Fluorphenyl, 1-Naphthyl, 2-Naphthyl, *ortho*-Xylyl, *meta*-Xylyl, *para*-Xylyl, Mesityl, $N(Phenyl)_2$, $N(p\text{-}Tolyl)_2$, $N(1\text{-}Naphthyl)_2$, $N(2\text{-}Naphthyl)_2$ und $N(p\text{-}Fluorphenyl)_2$.
Mindestens einer der Reste $R_d$ an den Einheiten (D1) bis (D4) und (G1) bis (G4) in ortho-Position zur Verknüpfung der Gruppe D mit A bzw. G mit A ist bevorzugt gewählt aus der Gruppe bestehend aus *tert*-Butyl, $N(Phenyl)_2$, $N(p\text{-}Tolyl)_2$, $N(1\text{-}Naphthyl)_2$, $N(2\text{-}Naphthyl)_2$, $N(p\text{-}Fluorphenyl)_2$, Phenyl, *ortho*-Tolyl, *meta*-Tolyl, *para*-Tolyl, *ortho*-Fluorphenyl, *meta*-Fluorphenyl, *para*-Fluorphenyl, 1-Naphthyl, 2-Naphthyl, *ortho*-Xylyl, *meta*-Xylyl, *para*-Xylyl und Mesityl. Die anderen Reste $R_d$ an den Einheiten (D1) bis (D4) und (G1) bis (G4) und an den Einheiten (D5) bis (D12) und (G5) bis (G12) werden bevorzugt gewählt aus der Gruppe bestehend aus Methyl, *tert*-Butyl, Fluor, $N(Phenyl)_2$, $N(p\text{-}Tolyl)_2$, $N(1\text{-}Naphthyl)_2$, $N(2\text{-}Naphthyl)_2$, $N(p\text{-}Fluorphenyl)_2$, Phenyl, *ortho*-Tolyl, *meta*-Tolyl, *para*-Tolyl, *ortho*-Fluorphenyl, *meta*-Fluorphenyl, *para*-Fluorphenyl, 1-Naphthyl, 2-Naphthyl, *ortho*-Xylyl, *meta*-Xylyl, *para*-Xylyl und Mesityl, wobei in den Einheiten (D2) und (G2) die beiden Substituenten $R_d$ in ortho-Position zur Verknüpfung der Gruppe D mit A bzw. G mit A verschieden gewählt sind. Weiterhin können an den Einheiten (D1), (G1), (D2), (G2), (D3), (G3), (D9) bis D(12) und (G9) bis (G12) die Reste $R_d$ in para-Position zur Verknüpfung der Gruppe D mit A bzw. G mit A auch Wasserstoff sein. Weiterhin können die Reste $R_a$ an den Einheiten (D3), (G3), (D11) und (G11) auch Wasserstoff sein.

Einheiten A:

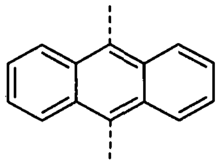

(A4)

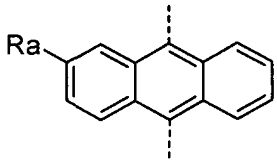

(A5)

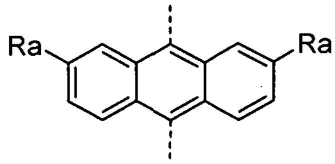

(A6)

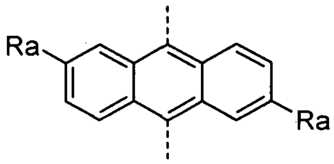

(A7)

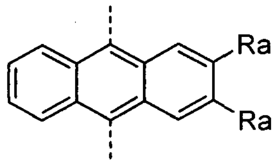

(A8)

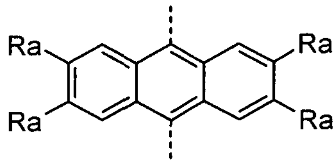

(A9)

Einheiten D und G:

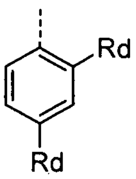

(D1)
(G1)

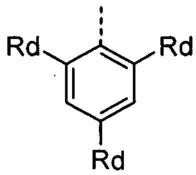

(D2)
(G2)

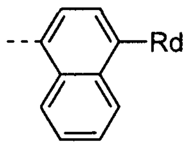

(D3)
(G3)

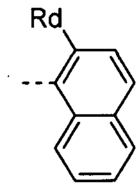

(D4)
(G4)

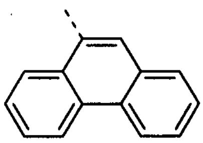

(D5)
(G5)

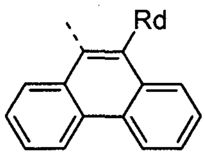

(D6)
(G6)

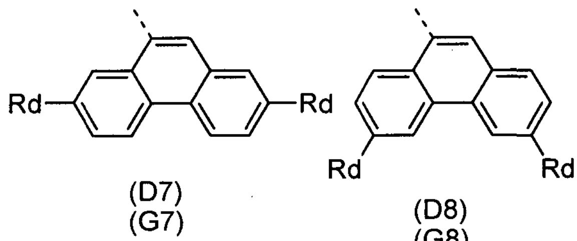

(D7)
(G7)

(D8)
(G8)

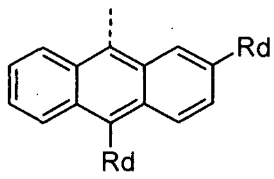

(D9)
(G9)

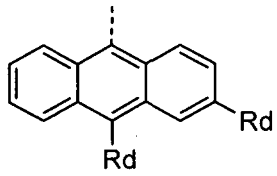

(D10)
(G10)

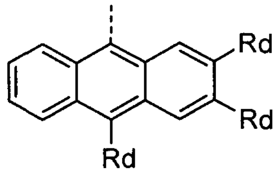

(D11)
(G11)

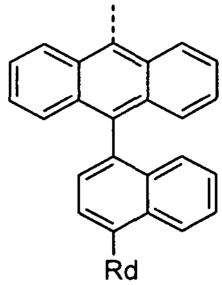

(D12)
(G12)

Besonders bevorzugt sind die in der Tabelle 2 aufgeführten Strukturen, die jeweils an den oben genannten Positionen mit den oben genannten Resten $R_a$ bzw. $R_d$ substituiert sind.

Tabelle 2: Besonders bevorzugte Strukturen

| Nr. | Stereochemie | A | D | G |
|---|---|---|---|---|
| 1* | syn | (A1) | (D1) | (G1) |
| 2* | anti | (A1) | (D1) | (G1) |
| 3* | syn | (A1) | (D1) | (G2) |
| 4* | anti | (A1) | (D1) | (G2) |
| 5* | syn | (A1) | (D1) | (G3) |
| 6* | anti | (A1) | (D1) | (G3) |
| 7* | syn | (A1) | (D1) | (G9) |
| 8* | anti | (A1) | (D1) | (G9) |
| 9* | syn | (A1) | (D1) | (G10) |
| 10* | anti | (A1) | (D1) | (G10) |
| 11* | syn | (A1) | (D1) | (G11) |
| 12* | anti | (A1) | (D1) | (G11) |
| 13* | syn | (A1) | (D1) | (G12) |
| 14* | anti | (A1) | (D1) | (G12) |
| 15* | syn | (A1) | (D2) | (G2) |
| 16* | anti | (A1) | (D2) | (G2) |
| 17* | syn | (A1) | (D2) | (G3) |
| 18* | anti | (A1) | (D2) | (G3) |
| 19* | syn | (A1) | (D2) | (G9) |
| 20* | anti | (A1) | (D2) | (G9) |
| 21* | syn | (A1) | (D2) | (G10) |
| 22* | anti | (A1) | (D2) | (G10) |
| 23* | syn | (A1) | (D2) | (G11) |
| 24* | anti | (A1) | (D2) | (G11) |
| 25* | syn | (A1) | (D2) | (G12) |
| 26* | anti | (A1) | (D2) | (G12) |
| 27* | syn | (A1) | (D3) | (G3) |
| 28* | anti | (A1) | (D3) | (G3) |
| 29* | syn | (A1) | (D3) | (G9) |
| 30* | anti | (A1) | (D3) | (G9) |
| 31* | syn | (A1) | (D3) | (G10) |
| 32* | anti | (A1) | (D3) | (G10) |
| 33* | syn | (A1) | (D3) | (G11) |
| 34* | anti | (A1) | (D3) | (G11) |

(fortgesetzt)

| Nr. | Stereochemie | A | D | G |
|---|---|---|---|---|
| 35* | syn | (A1) | (D3) | (G12) |
| 36* | anti | (A1) | (D3) | (G12) |
| 37* | syn | (A1) | (D9) | (G9) |
| 38* | anti | (A1) | (D9) | (G9) |
| 39* | syn | (A1) | (D9) | (G10) |
| 40* | anti | (A1) | (D9) | (G10) |
| 41* | syn | (A1) | (D9) | (G11) |
| 42* | anti | (A1) | (D9) | (G11) |
| 43* | syn | (A1) | (D9) | (G12) |
| 44* | anti | (A1) | (D9) | (G12) |
| 45* | syn | (A1) | (D10) | (G10) |
| 46* | anti | (A1) | (D10) | (G10) |
| 47* | syn | (A1) | (D10) | (G11) |
| 48* | anti | (A1) | (D10) | (G11) |
| 49* | syn | (A1) | (D10) | (G12) |
| 50* | anti | (A1) | (D10) | (G12) |
| 51* | syn | (A1) | (D11) | (G11) |
| 52* | anti | (A1) | (D11) | (G11) |
| 53* | syn | (A1) | (D11) | (G12) |
| 54* | anti | (A1) | (D11) | (G12) |
| 55* | syn | (A1) | (D12) | (G12) |
| 56* | anti | (A1) | (D12) | (G12) |
| 57 | syn | (A4) | (D1) | (G1) |
| 58 | anti | (A4) | (D1) | (G1) |
| 59 | syn | (A4) | (D1) | (G2) |
| 60 | anti | (A4) | (D1) | (G2) |
| 61 | syn | (A4) | (D1) | (G3) |
| 62 | anti | (A4) | (D1) | (G3) |
| 63 | syn | (A4) | (D1) | (G9) |
| 64 | anti | (A4) | (D1) | (G9) |
| 65 | syn | (A4) | (D1) | (G10) |
| 66 | anti | (A4) | (D1) | (G10) |
| 67 | syn | (A4) | (D1) | (G11) |
| 68 | anti | (A4) | (D1) | (G11) |
| 69 | syn | (A4) | (D1) | (G12) |
| 70 | anti | (A4) | (D1) | (G12) |
| 71 | syn | (A4) | (D2) | (G2) |
| 72 | anti | (A4) | (D2) | (G2) |
| 73 | syn | (A4) | (D2) | (G3) |
| 74 | anti | (A4) | (D2) | (G3) |
| 75 | syn | (A4) | (D2) | (G9) |
| 76 | anti | (A4) | (D2) | (G9) |
| 77 | syn | (A4) | (D2) | (G10) |
| 78 | anti | (A4) | (D2) | (G10) |
| 79 | syn | (A4) | (D2) | (G11) |
| 80 | anti | (A4) | (D2) | (G11) |
| 81 | syn | (A4) | (D2) | (G12) |
| 82 | anti | (A4) | (D2) | (G12) |
| 82 | syn | (A4) | (D3) | (G3) |

(fortgesetzt)

| Nr. | Stereochemie | A | D | G |
|---|---|---|---|---|
| 84 | anti | (A4) | (D3) | (G3) |
| 85 | syn | (A4) | (D3) | (G9) |
| 86 | anti | (A4) | (D3) | (G9) |
| 87 | syn | (A4) | (D3) | (G10) |
| 88 | anti | (A4) | (D3) | (G10) |
| 89 | syn | (A4) | (D3) | (G11) |
| 90 | anti | (A4) | (D3) | (G11) |
| 91 | syn | (A4) | (D3) | (G12) |
| 92 | anti | (A4) | (D3) | (G12) |
| 93 | syn | (A4) | (D9) | (G9) |
| 94 | anti | (A4) | (D9) | (G9) |
| 95 | syn | (A4) | (D9) | (G10) |
| 96 | anti | (A4) | (D9) | (G10) |
| 97 | syn | (A4) | (D9) | (G11) |
| 98 | anti | (A4) | (D9) | (G11) |
| 99 | syn | (A4) | (D9) | (G12) |
| 100 | anti | (A4) | (D9) | (G12) |
| 101 | syn | (A4) | (D10) | (G10) |
| 102 | anti | (A4) | (D10) | (G10) |
| 103 | syn | (A4) | (D10) | (G11) |
| 104 | anti | (A4) | (D10) | (G11) |
| 105 | syn | (A4) | (D10) | (G12) |
| 106 | anti | (A4) | (D10) | (G12) |
| 107 | syn | (A4) | (D11) | (G11) |
| 108 | anti | (A4) | (D11) | (G11) |
| 109 | syn | (A4) | (D11) | (G12) |
| 110 | anti | (A4) | (D11) | (G12) |
| 111 | syn | (A4) | (D12) | (G12) |
| 112 | anti | (A4) | (D12) | (G12) |
| 113 | syn | (A5) | (D1) | (G1) |
| 114 | anti | (A5) | (D1) | (G1) |
| 115 | syn | (A5) | (D1) | (G2) |
| 116 | anti | (A5) | (D1) | (G2) |
| 117 | syn | (A5) | (D1) | (G3) |
| 118 | anti | (A5) | (D1) | (G3) |
| 119 | syn | (A5) | (D1) | (G9) |
| 120 | anti | (A5) | (D1) | (G9) |
| 121 | syn | (A5) | (D1) | (G10) |
| 122 | anti | (A5) | (D1) | (G10) |
| 123 | syn | (A5) | (D1) | (G11) |
| 124 | anti | (A5) | (D1) | (G11) |
| 125 | syn | (A5) | (D1) | (G12) |
| 126 | anti | (A5) | (D1) | (G12) |
| 127 | syn | (A5) | (D2) | (G2) |
| 128 | anti | (A5) | (D2) | (G2) |
| 129 | syn | (A5) | (D2) | (G3) |
| 130 | anti | (A5) | (D2) | (G3) |
| 131 | syn | (A5) | (D2) | (G9) |
| 132 | anti | (A5) | (D2) | (G9) |

(fortgesetzt)

| Nr. | Stereochemie | A | D | G |
|---|---|---|---|---|
| 133 | syn | (A5) | (D2) | (G10) |
| 134 | anti | (A5) | (D2) | (G10) |
| 135 | syn | (A5) | (D2) | (G11) |
| 136 | anti | (A5) | (D2) | (G11) |
| 137 | syn | (A5) | (D2) | (G12) |
| 138 | anti | (A5) | (D2) | (G12) |
| 139 | syn | (A5) | (D3) | (G3) |
| 140 | anti | (A5) | (D3) | (G3) |
| 141 | syn | (A5) | (D3) | (G9) |
| 142 | anti | (A5) | (D3) | (G9) |
| 143 | syn | (A5) | (D3) | (G10) |
| 144 | anti | (A5) | (D3) | (G10) |
| 145 | syn | (A5) | (D3) | (G11) |
| 146 | anti | (A5) | (D3) | (G11) |
| 147 | syn | (A5) | (D3) | (G12) |
| 148 | anti | (A5) | (D3) | (G12) |
| 149 | syn | (A5) | (D9) | (G9) |
| 150 | anti | (A5) | (D9) | (G9) |
| 151 | syn | (A5) | (D9) | (G10) |
| 152 | anti | (A5) | (D9) | (G10) |
| 153 | syn | (A5) | (D9) | (G11) |
| 154 | anti | (A5) | (D9) | (G11) |
| 155 | syn | (A5) | (D9) | (G12) |
| 156 | anti | (A5) | (D9) | (G12) |
| 157 | syn | (A5) | (D10) | (G10) |
| 158 | anti | (A5) | (D10) | (G10) |
| 159 | syn | (A5) | (D10) | (G11) |
| 160 | anti | (A5) | (D10) | (G11) |
| 161 | syn | (A5) | (D10) | (G12) |
| 162 | anti | (A5) | (D10) | (G12) |
| 163 | syn | (A5) | (D11) | (G11) |
| 164 | anti | (A5) | (D11) | (G11) |
| 165 | syn | (A5) | (D11) | (G12) |
| 166 | anti | (A5) | (D11) | (G12) |
| 167 | syn | (A5) | (D12) | (G12) |
| 168 | anti | (A5) | (D12) | (G12) |
| 169 | syn | (A9) | (D1) | (G1) |
| 170 | anti | (A9) | (D1) | (G1) |
| 171 | syn | (A9) | (D1) | (G2) |
| 172 | anti | (A9) | (D1) | (G2) |
| 173 | syn | (A9) | (D1) | (G3) |
| 174 | anti | (A9) | (D1) | (G3) |
| 175 | syn | (A9) | (D1) | (G9) |
| 176 | anti | (A9) | (D1) | (G9) |
| 177 | syn | (A9) | (D1) | (G10) |
| 178 | anti | (A9) | (D1) | (G10) |
| 179 | syn | (A9) | (D1) | (G11) |
| 180 | anti | (A9) | (D1) | (G11) |
| 181 | syn | (A9) | (D1) | (G12) |

(fortgesetzt)

| Nr. | Stereochemie | A | D | G |
|---|---|---|---|---|
| 182 | anti | (A9) | (D1) | (G12) |
| 183 | syn | (A9) | (D2) | (G2) |
| 184 | anti | (A9) | (D2) | (G2) |
| 185 | syn | (A9) | (D2) | (G3) |
| 186 | anti | (A9) | (D2) | (G3) |
| 187 | syn | (A9) | (D2) | (G9) |
| 188 | anti | (A9) | (D2) | (G9) |
| 189 | syn | (A9) | (D2) | (G10) |
| 190 | anti | (A9) | (D2) | (G10) |
| 191 | syn | (A9) | (D2) | (G11) |
| 192 | anti | (A9) | (D2) | (G11) |
| 193 | syn | (A9) | (D2) | (G12) |
| 194 | anti | (A9) | (D2) | (G12) |
| 195 | syn | (A9) | (D3) | (G3) |
| 196 | anti | (A9) | (D3) | (G3) |
| 197 | syn | (A9) | (D3) | (G9) |
| 198 | anti | (A9) | (D3) | (G9) |
| 199 | syn | (A9) | (D3) | (G10) |
| 200 | anti | (A9) | (D3) | (G10) |
| 201 | syn | (A9) | (D3) | (G11) |
| 202 | anti | (A9) | (D3) | (G11) |
| 203 | syn | (A9) | (D3) | (G12) |
| 204 | anti | (A9) | (D3) | (G12) |
| 205 | syn | (A9) | (D9) | (G9) |
| 206 | anti | (A9) | (D9) | (G9) |
| 207 | syn | (A9) | (D9) | (G10) |
| 208 | anti | (A9) | (D9) | (G10) |
| 209 | syn | (A9) | (D9) | (G11) |
| 210 | anti | (A9) | (D9) | (G11) |
| 211 | syn | (A9) | (D9) | (G12) |
| 212 | anti | (A9) | (D9) | (G12) |
| 213 | syn | (A9) | (D10) | (G10) |
| 214 | anti | (A9) | (D10) | (G10) |
| 215 | syn | (A9) | (D10) | (G11) |
| 216 | anti | (A9) | (D10) | (G11) |
| 217 | syn | (A9) | (D10) | (G12) |
| 218 | anti | (A9) | (D10) | (G12) |
| 219 | syn | (A9) | (D11) | (G11) |
| 220 | anti | (A9) | (D11) | (G11) |
| 221 | syn | (A9) | (D11) | (G12) |
| 222 | anti | (A9) | (D11) | (G12) |
| 223 | syn | (A9) | (D12) | (G12) |
| 224 | anti | (A9) | (D12) | (G12) |
| 225* | syn | (A10) | (D1) | (G1) |
| 226* | anti | (A10) | (D1) | (G1) |
| 227* | syn | (A10) | (D1) | (G2) |
| 228* | anti | (A10) | (D1) | (G2) |
| 229* | syn | (A10) | (D1) | (G3) |
| 230* | anti | (A10) | (D1) | (G3) |

(fortgesetzt)

| Nr. | Stereochemie | A | D | G |
|---|---|---|---|---|
| 231* | syn | (A10) | (D1) | (G9) |
| 232* | anti | (A10) | (D1) | (G9) |
| 233* | syn | (A10) | (D1) | (G10) |
| 234* | anti | (A10) | (D1) | (G10) |
| 235* | syn | (A10) | (D1) | (G11) |
| 236* | anti | (A10) | (D1) | (G11) |
| 237* | syn | (A10) | (D1) | (G12) |
| 238* | anti | (A10) | (D1) | (G12) |
| 239* | syn | (A10) | (D2) | (G2) |
| 240* | anti | (A10) | (D2) | (G2) |
| 241* | syn | (A10) | (D2) | (G3) |
| 242* | anti | (A10) | (D2) | (G3) |
| 243* | syn | (A10) | (D2) | (G9) |
| 244* | anti | (A10) | (D2) | (G9) |
| 245* | syn | (A10) | (D2) | (G10) |
| 246* | anti | (A10) | (D2) | (G10) |
| 247* | syn | (A10) | (D2) | (G11) |
| 248* | anti | (A10) | (D2) | (G11) |
| 249* | syn | (A10) | (D2) | (G12) |
| 250* | anti | (A10) | (D2) | (G12) |
| 251* | syn | (A10) | (D3) | (G3) |
| 252* | anti | (A10) | (D3) | (G3) |
| 253* | syn | (A10) | (D3) | (G9) |
| 254* | anti | (A10) | (D3) | (G9) |
| 255* | syn | (A10) | (D3) | (G10) |
| 256* | anti | (A10) | (D3) | (G10) |
| 257* | syn | (A10) | (D3) | (G11) |
| 258* | anti | (A10) | (D3) | (G11) |
| 259* | syn | (A10) | (D3) | (G12) |
| 260* | anti | (A10) | (D3) | (G12) |
| 261* | syn | (A10) | (D9) | (G9) |
| 262* | anti | (A10) | (D9) | (G9) |
| 263* | syn | (A10) | (D9) | (G10) |
| 264* | anti | (A10) | (D9) | (G10) |
| 265* | syn | (A10) | (D9) | (G11) |
| 266* | anti | (A10) | (D9) | (G11) |
| 267* | syn | (A10) | (D9) | (G12) |
| 268* | anti | (A10) | (D9) | (G12) |
| 269* | syn | (A10) | (D10) | (G10) |
| 270* | anti | (A10) | (D10) | (G10) |
| 270* | syn | (A10) | (D10) | (G11) |
| 272* | anti | (A10) | (D10) | (G11) |
| 273* | syn | (A10) | (D10) | (G12) |
| 274* | anti | (A10) | (D10) | (G12) |
| 275* | syn | (A10) | (D11) | (G11) |
| 276* | anti | (A10) | (D11) | (G11) |
| 277* | syn | (A10) | (D11) | (G12) |
| 278* | anti | (A10) | (D11) | (G12) |
| 279* | syn | (A10) | (D12) | (G12) |

(fortgesetzt)

| Nr. | Stereochemie | A | D | G |
|---|---|---|---|---|
| 280* | anti | (A10) | (D12) | (G12) |
| *Nicht erfindungsmäßig | | | | |

Atropisomerengemische der Formel (1), in denen A und gegebenenfalls auch D und G für kondensierte aromatische Ringsysteme stehen, die zur Bildung von Diastereomeren befähigt sind und in denen ein Überschuss eines Atropisomers (Diastereomers) gegenüber dem anderen Atropisomer (Diastereomer) vorliegt, sind neu und daher ebenfalls ein Gegenstand der vorliegenden Erfindung.

Gegenstand der Erfindung sind daher weiterhin Atropisomerengemische gemäß Formel (1),

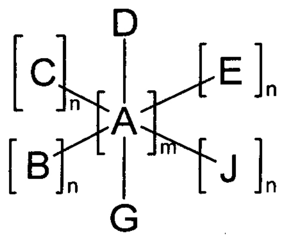

Formel (1)

wobei R, $R^1$, dieselbe Bedeutung haben, wie oben beschrieben, und für die weiteren verwendeten Symbole gilt:

A ist 9, 10-Anthracen, das durch R substituiert oder unsubstituiert ist;

B, C, D, E, G, J ist bei jedem Auftreten gleich oder verschieden ein aromatisches oder heteroaromatisches Ringsystem mit 5 bis 40 aromatischen Ringatomen, das unsubstituiert oder durch R substituiert sein kann, mit der Maßgabe, dass in ortho-Position zur Verknüpfung zu A mindestens ein aromatischer Rest R vorhanden ist, der auch an die entsprechende Einheit B bis J ankondensiert sein kann;

m ist 1;

n ist 0;

dadurch gekennzeichnet, dass ein Atropisomerenüberschuss eines Atropisomers von mindestens 70 % vorliegt und die Atropisomerie durch gehinderte Rotation um C-C-Einfachbindungen erzeugt wird.

Das Atropisomerengemisch der Formel (1) besteht bevorzugt nur aus den Atropisomeren einer Verbindung, d. h. es handelt sich bevorzugt um eine Mischung von Atropisomeren, ohne dass die Mischung weitere Komponenten enthält.

Bevorzugt ist ein Atropisomerenüberschuss von mindestens 90 %, mindestens 95 % bzw. mindestens 99 %. Größere Atropisomerenüberschüsse sind bevorzugt, da dadurch eine bessere Reproduzierbarkeit bei Herstellung und Betrieb der organischen elektronischen Vorrichtung gewährleistet ist.

Bevorzugte kondensierte aromatische Ringsysteme sind solche, wie sie bereits oben ausgeführt wurden.

Besonders bevorzugt sind B, C, D, E, G und J unabhängig voneinander ausgewählt aus 1-Naphthyl, ortho-Biphenyl, 1-Anthryl, welche jeweils durch R substituiert oder unsubstituiert sein können. Weiterhin besonders bevorzugt sind diese Gruppen ausgewählt aus den entsprechenden Aza-Analoga.

Ganz besonders bevorzugt sind weiterhin die Verbindungen aus Tabelle 2.

Die Synthese der Verbindungen gemäß Formel (1) erfolgt gewöhnlicherweise, indem zunächst gemäß der Literatur die Mischung der Atropisomeren synthetisiert wird, die statistisch in einem Verhältnis von ca. 1 : 1 vorliegen. Die Anreicherung und Isolierung eines der Atropisomeren kann in einem Folgeschritt beispielsweise durch Ausnutzung unterschiedlicher Löslichkeit erfolgen, beispielsweise durch Umkristallisation. Dabei kann es sinnvoll sein, die Verbindung gemäß Formel (1) geeignet zu substituieren, wodurch sich die Löslichkeit der unterschiedlichen Atropisomere zu unterschiedlichem Anteil ändern kann. So kann es beispielsweise durch geeignete Substitution möglich sein, ein Atropisomer zu erhalten, welches gut in einer großen Bandbreite organischer Lösemittel löslich ist, während das andere Atropisomer, das zum ersten Atropisomer diastereomer ist, in diesen Lösemitteln nahezu unlöslich ist. Dadurch kann in manchen

Fällen die Trennung der Isomere einfach möglich werden, die ansonsten nur mit hohem experimentellem Aufwand möglich wäre. Auch weitere gängige Trennmethoden der organischen Chemie können eingesetzt werden, so beispielsweise Säulenchromatographie, präparative HPLC, Destillation, Sublimation, fraktionierte Kristallisation oder Extraktion (z. B. Soxhlett-Extraktion). Sollen zusätzlich zu den Diastereomeren einzelne Enantiomere angereichert oder isoliert werden, bietet sich hierfür die Chromatographie an chiralen Festphasen an.

Für manche Verbindungen, insbesondere solche mit großen Substituenten, besteht die Möglichkeit, dass direkt bei der Synthese bereits eines der Atropisomere im Überschuss oder in weitgehend reiner Form entsteht.
Auch die Ausnutzung des Templat-Effekts kann für die Synthese möglich sein. Dabei wird eines der möglichen Atropisomere bereits in Lösung bei der Synthese durch Zugabe eines Templats (beispielsweise ein geeignetes Metallion) selektiert und dadurch im deutlichen Überschuss gebildet.

Das Atropisomere, das nicht angereichert bzw. isoliert wird, kann durch Reisomerisierung, beispielsweise durch ausreichend langes Erhitzen in einem geeigneten Lösemittel, durch Behandlung mit Ultraschall und/oder mit Mikrowellen, wieder mit dem anderen Atropisomeren ins Gleichgewicht gebracht werden. Der Vorgang der Isomerentrennung kann also ohne Verlust durchgeführt werden.

Wie oben ausgeführt, ist es durch geeignete Substitution möglich, gut lösliche bzw. unlösliche Atropisomere derselben Verbindung zu erhalten. Auf analoge Weise ist es möglich, beispielsweise durch Verwendung des löslicheren Atropisomeren als Monomer gut lösliche Polymere, Oligomere oder Dendrimere zu erhalten, ohne dass viele und/oder große organische Reste, beispielsweise Alkyl- oder Alkoxygruppen mit 4 und mehr C-Atomen, nötig sind, die nichts zur elektronischen Funktion des Polymers beitragen, die jedoch bislang zur Synthese löslicher konjugierter Polymere nach Stand der Technik nötig sind. Wird hingegen das weniger lösliche Atropisomer oder eine Mischung der beiden Atropisomere verwendet, die das unlöslichere Atropisomer zu gleichen Anteilen oder im Überschuss enthält, so sind im Allgemeinen auch die erhaltenen Polymere, Oligomere oder Dendrimere schlecht löslich.

Gegenstand der Erfindung sind daher weiterhin konjugierte, teilkonjugierte oder nicht-konjugierte Polymere, Oligomere oder Dendrimere, enthaltend Wiederholeinheiten, die Atropisomere bilden und dadurch zur Bildung von Diastereomeren befähigt sind, dadurch gekennzeichnet, dass ein Atropisomerenüberschuss von mindestens 10 % verwendet wird.

So können diese Wiederholeinheiten unter anderem in Polyfluorene (z. B. gemäß EP 842208 oder WO 00/22026), Poly-spirobifluorene (z. B. gemäß EP 707020 oder EP 894107), Poly-para-phenylene (z. B. gemäß WO 92/18552), Polydihydrophenanthrene (z. B. gemäß WO 05/014689), Poly-phenanthrene (z. B. gemäß DE 102004020298.2), Poly-indenofluorene (z. B. gemäß WO 04/041901 oder WO 04/113412), Poly-carbazole, Poly-anthracene, Poly-naphthaline oder auch Polythiophene (z. B. gemäß EP 1028136) einpolymerisiert werden. Auch Polymere mit mehreren dieser Einheiten oder Homopolymere der atropisomeren Wiederholeinheiten sind möglich.

Es ist bevorzugt, dass im Polymer, Oligomer oder Dendrimer das Atropisomer, das im Überschuss verwendet wird, besser löslich ist als das Atropisomer, das im Unterschuss verwendet wird.

In einer bevorzugten Ausführungsform der Erfindung ist der Atropisomerenüberschuss im Polymer, Oligomer oder Dendrimer mindestens 20 %, besonders bevorzugt mindestens 50 %, ganz besonders bevorzugt mindestens 70 %, insbesondere mindestens 90 %, mindestens 95 % bzw. mindestens 99 %. Größere Atropisomerenüberschüsse sind bevorzugt, da dadurch eine bessere Löslichkeit der Polymere, Oligomere oder Dendrimere gewährleistet ist.

Weiterhin bevorzugt ist eine organische elektronische Vorrichtung, dadurch gekennzeichnet, dass eine oder mehrere Schichten mit einem Sublimationsverfahren beschichtet werden. Dabei werden die Materialien in Vakuum-Sublimationsanlagen bei einem Druck kleiner $10^{-5}$ mbar, bevorzugt kleiner $10^{-6}$ mbar, besonders bevorzugt kleiner $10^{-7}$ mbar aufgedampft.

Bevorzugt ist ebenfalls eine organische elektronische Vorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien in der Regel bei einem Druck zwischen $10^{-5}$ mbar und 1 bar aufgebracht.

Weiterhin bevorzugt ist eine organische elektronische Vorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck oder Offsetdruck, besonders bevorzugt aber LITI (Light Induced Thermal Imaging, Thermotransferdruck) oder Ink-Jet Druck (Tintenstrahl-Druck), hergestellt werden.

Die oben beschriebenen emittierenden Vorrichtungen weisen folgende überraschende Vorteile gegenüber dem Stand der Technik, der Mischungen mit einem Atropisomerenverhältnis von ca. 1 : 1 verwendet, auf:

1. Die Stabilität entsprechender Vorrichtungen ist größer im Vergleich zu Systemen gemäß dem Stand der Technik, was sich vor allem in einer längeren Lebensdauer zeigt.
2. Die organischen elektronischen Vorrichtungen lassen sich mit besserer Reproduzierbarkeit herstellen, da statt Stoffmischungen, deren Einzelkomponenten unterschiedliche Sublimationstemperaturen und andere physikalische Eigenschaften aufweisen, Verbindungen mit starker Anreicherung eines Isomeren bzw. reine Isomere verwendet

werden. Diese führen auch in der Vorrichtung zu einheitlicheren Schichten und zu besserer Reproduzierbarkeit im Betrieb der Vorrichtung.

3. Im Gegensatz zu den bisher verwendeten Verbindungen, die teilweise durch schlechte Löslichkeit schwierig zu reinigen waren, können durch die Anreicherung löslichere Isomere isoliert werden, die in Folge einfacher zu reinigen sind bzw. auch leichter aus Lösung verarbeitet werden können.

4. Überraschend wurde gefunden, dass die Atropisomere trotz der verwendeten hohen Temperaturen bei der Sublimation im Hochvakuum stabil sind und nicht oder nur in ganz untergeordnetem Maße beim Aufdampfen isomerisieren. Dies ist eine wesentliche Eigenschaft, um zu gewährleisten, dass das eingesetzte Isomer auch in der organischen elektronischen Vorrichtung in derselben Form vorliegt.

5. Bei der Trennung der Isomere muss das nicht verwendete Isomer nicht verworfen werden, sondern dieses kann durch ausreichend langes Erhitzen in einem geeigneten Lösemittel oder ändere Behandlung wieder mit dem anderen Atropisomeren ins Gleichgewicht gebracht werden. Der Vorgang der Isomerentrennung kann so ohne Verlust durchgeführt werden.

Die Erfindung wird durch die nachfolgenden Beispiele näher erläutert, ohne sie dadurch einschränken zu wollen.

**Beispiele:**

Die nachfolgenden Synthesen wurden, sofern nicht anders angegeben, unter einer Schutzgasatmosphäre durchgeführt. Die Edukte wurden von den Fa. ALDRICH bzw. ABCR (9,10-Dibromanthracen, 4-Methylnaphthalin-1-boronsäure, 2-Formylboronsäure, 2-Methoxybenzolboronsäure, 2-(Methylthio)phenylboronsäure, Palladium(II)acetat, Tri-o-tolylphosphin, Anorganika, Lösemittel) bezogen.

**Beispiel 1: 9,10-Bis(4-methylnaphth-1-yl)anthracen (Anthracen-Derivat A1) a) Synthese des Atropisomerengemischs von Anthracen-Derivats A1**

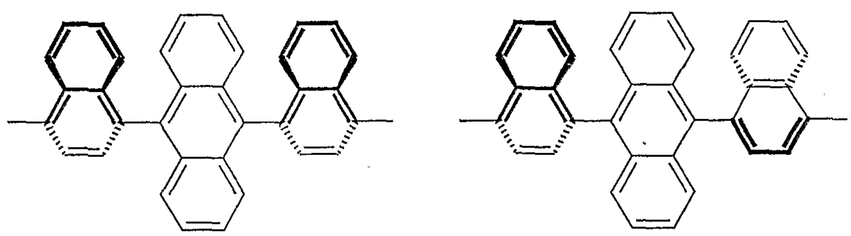

syn-Form anti-Form

Eine entgaste, gut gerührte Suspension von 74.4 g (400 mmol) 4-Methylnaphthalin-1-boronsäure, 33.6 g (100 mmol) 9,10-Dibromanthracen und 104.3 g (420 mmol) Kaliumphosphat-monohydrat in einem Gemisch aus 300 ml Toluol, 150 ml Dioxan und 400 ml Wasser wurde mit 1.83 g (6 mmol) Tris-o-tolylphosphin und dann mit 225 mg (1 mmol) Palladium(II)acetat versetzt und anschließend 16 h unter Rückfluss erhitzt. Nach Erkalten der Reaktionsmischung auf Raumtemperatur wurde vom ausgefallenen Feststoff abgesaugt. Dieser wurde dreimal mit je 200 ml Wasser und dreimal mit je 100 ml Ethanol gewaschen. Nach Trocknen im Vakuum (1 mbar, 80 °C, 16 h) wurde das Produkt in einem Soxhlett-Extraktor mit Chloroform durch eine Glasfaserextraktionshülse (Porengröße 0.1 μm) extrahiert, um Palladiumspuren zu entfernen. Das Chloroform wurde auf ein Volumen von 100 ml eingeengt und mit 500 ml Ethanol versetzt. Der resultierende Niederschlag wurde abgesaugt und mit Ethanol gewaschen. Die Ausbeute an Rohprodukt **A1** betrug 41.3 g (90 mmol), 90.0 % der Theorie.

**b) Bestimmung des Atropisomerenverhältnisses des Rohprodukts von A1 *Mittels HPLC:***

2 mg des oben beschriebenen Rohprodukts wurden in 10 ml THF gelöst. 5 μl dieser Lösung wurden unter Verwendung eines Agilent LC 1100 HPLC auf einer Zorbax SB-C18 (4.5 x 75 mm, 3.5 Mikron) bei 40 °C und einer Flussrate des Eluenten (72 % Methanol / 8 % THF / 20 % Wasser) von 1 ml/min getrennt.

Die Retentionszeiten [min] und Flächen-% der Atropisomeren betrugen:

| | | |
|---|---|---|
| Atropisomer **1:** | 32.45 min | ca. 47 Flächen-% |
| Atropisomer **2:** | 33.84 min | ca. 53 Flächen-% |

Dies entspricht einem Atropisomerenüberschuss von ca. 6 %. Die UV/Vis-Spektren beider Atropisomeren - entnommen aus den HPLC-Peaks - sind nahezu identisch.

***Mittels $^1$H-NMR-Spektroskopie:***

Die $^1$H-NMR-Spektren wurden auf einem DMX-500 MHz Spektrometer der Fa. Bruker aufgenommen.

Das $^1$H-NMR-Spektrum des oben beschriebenen Atropisomerengemischs ist, bedingt durch die weitgehende Überlappung der Signale der Atropisomere 1 und 2, komplex; jedoch kann das relative molare Verhältnis der Atropisomeren aus zwei überlagerten, aber ausreichend separierten Dubletts, die den 8-Naphthyl-Protonen zuzuordnen sind, bestimmt werden:

Atropisomer **1:** $\delta$ (8-Naphthyl-Proton): 8.21 ppm (d, $^3J_{HH}$ = 8.3 Hz); ca. 46 %
Atropisomer **2:** $\delta$ (8-Naphthyl-Proton): 8.20 ppm (d, $^3J_{HH}$ = 8.3 Hz); ca. 54 %

**c) Präparative Trennung der Atropisomeren von A1**

***Anreicherung des Atropisomeren 2:***

40.0 g des oben als Rohprodukt beschriebenen Gemischs der Atropisomeren von **A1** mit einem Verhältnis von Atropisomer **1** zu Atropisomer **2** von ca. 47 % : 53 % wurden in 2000 ml N-Methylpyrrolidinon (NMP) suspendiert. Diese Suspension wurde in ein 250 °C warmes Ölbad gestellt. Nach ca. 10 min. betrug die Temperatur des N-Methylpyrrolidinon etwa 200 °C, und das Gemisch der Atropisomeren war in Lösung gegangen. Nach langsamen Erkalten der Lösung wurde der entstandene feinkristalline Niederschlag abgesaugt, dreimal mit je 100 ml mit NMP und dreimal mit 100 ml Ethanol gewaschen. Die Ausbeute betrug 18.3 g, wobei es sich um ein angereichertes Gemisch der Atropisomeren **1** und **2** im Verhältnis von ca. 10 % : 90 % handelt, entsprechend einem Atropisomerenüberschuss von **2** von 80 %.

***Anreicherung des Atropisomeren 1:***

Die N-Methylpyrrolidinon-Mutterlauge aus obiger Umkristallisation wurde mit 300 ml Ethanol versetzt. Der nach 16 h stehen bei Raumtemperatur entstandene feinkristalline Niederschlag wurde abgesaugt. Die so erhaltenen 5.4 g Produkt bestanden aus einem angereicherten Gemisch der Atropisomeren **1** und **2** im Verhältnis von ca. 84 % : 16 %, entsprechend einem Atropisomerenüberschuss von 68 %. Die Mutterlauge aus dem letztgenannten Schritt wurde erneut mit 500 ml Ethanol versetzt. Der nach 32 h stehen bei Raumtemperatur entstandene feinkristalline Niederschlag wurde abgesaugt. Die so erhaltenen 11.3 g Produkt bestanden aus einem angereicherten Gemisch der Atropisomeren **1** und **2** im Verhältnis von ca. 96 % : 4 %, entsprechend einem Atropisomerenüberschuss von **1** von 92 %.

***Reinisolierung des Atropisomeren 2:***

10.0 g des oben beschriebenen Gemischs, in dem das Atropisomer **2** auf einen Atropisomerenüberschuss von 80 % angereichert wurde, wurde erneut aus N-Methylpyrrolidinon umkristallisiert. Dazu wurden 800 ml N-Methylpyrrolidinon auf 190 °C erhitzt. Dann wurde das Gemisch mit einem Atropisomerenüberschuss des Atropisomeren **2** von 80 % unter gutem Rühren zugegeben. Nachdem eine klare Lösung entstanden war (ca. 5 min.), wurde die Heizquelle entfernt, und die Lösung kühlte unter Rühren auf Raumtemperatur ab (ca. 16 h). Der Feststoff wurde abgesaugt und mit etwas N-Methylpyrrolidinon gewaschen.

Nach zwei Umkristallisationen betrug die Ausbeute 7.9 g, wobei der Atropisomerenüberschuss an Atropisomer **2** auf mindestens 98 % abgeschätzt wird (Verhältnis 99 % : 1 %), da das Atropisomer **1** in dieser Fraktion weder mittels HPLC noch mittels $^1$H-NMR-Spektroskopie nachgewiesen werden konnte.

**d) Vergleich der Löslichkeit der Atropisomeren von A1**

Das Atropisomer **1** ist in allen gängigen, polaren organischen Lösungsmitteln, wie z. B. Dichlormethan, Chloroform, Aceton, THF, DMSO, DMF, NMP, etc., gut löslich. Im Gegensatz dazu ist das Atropisomer **2** in allen gängigen organischen Lösungsmitteln nur sehr schwer löslich. Die beste Löslichkeit zeigt es noch in dipolar aprotischen Lösungsmitteln wie DMF, NMP oder DMSO in der Siedehitze, aus welchen es auch umkristallisiert werden kann (s. o.).

**e) Thermische Isomerisierung der Atropisomeren von A1**

200 mg des Atropisomeren **2** mit einem Atropisomerenüberschuss von mindestens 98 % wurden in 10 ml N-Methylpyrrolidinon suspendiert. Diese Suspension wurde 6 h auf 200 °C erhitzt. Anschließend wurde der Atropisomerenüberschuss mittels HPLC (s. o.) bestimmt; er betrug 78 % bezüglich Atropisomer **2.** Durch längeres Erhitzen kann auch eine Mischung mit einem Atropisomerenverhältnis von ca. 1 : 1 erzeugt werden. Dies zeigt, dass durch geeignete experimentelle Bedingungen aus dem angereicherten Isomer wieder eine Isomerenmischung erzeugt werden kann.

Dadurch muss das nicht verwendete Isomer nicht verworfen werden, sondern kann, nach Isomerisierung, weiterhin verwendet werden.

**f) Sublimation der Atropisomeren von A1**

Die Sublimation der Atropisomeren von **A1** erfolgte im statischen Vakuum bei den unten angegebenen Bedingungen (Tabelle 3). Überraschend wurde gefunden, dass die Atropisomere unter den verwendeten Bedingungen der Sublimation nicht oder nur in ganz untergeordnetem Maße isomerisieren, wie der Vergleich des Atropisomerenüberschuss vor und nach der Sublimation zeigt. Weiterhin fällt auf, dass sich die beiden Atropisomeren stark in ihren Sublimationstemperaturen unterscheiden, was belegt, dass mit einer Mischung dieser Isomeren keine reproduzierbare Herstellung organischer elektronischer Vorrichtungen möglich ist.

**Tabelle 3:** Sublimation der Atropisomeren **1** und **2**

| Atropisomer | Druck [mbar] | Subl.-Temp. [°C] | Atropisomerenüberschuss vor Sublimation | Atropisomerenüberschuss nach Sublimation |
|---|---|---|---|---|
| **1** | 5 x $10^{-5}$ mbar | 320 | 92 % | 92 % |
| **2** | 5 x $10^{-5}$ mbar | 370 | 98 % | 97 % |

**g) Schmelz- und Glasübergangstemperaturen der Atropisomeren von A1**

Die Schmelzpunkte und die Glasübergangstemperaturen der beiden angereicherten Atropisomeren von **A1** wurde untersucht. Dabei wurde festgestellt, dass diese Temperaturen für die beiden Atropisomeren deutlich voneinander abweichen, was die unterschiedlichen morphologischen Eigenschaften der beiden Isomere belegt. Die Ergebnisse sind in Tabelle 4 zusammengefasst.

**Tabelle 4:** Schmelzpunkte und Glasübergangstemperaturen der Atropisomeren **1** und **2**

| Atropisomer | Atropisomerenüberschuss | Schmelzpunkt [°C] | Glasübergangstemperatur [°C] |
|---|---|---|---|
| **1** | 92 % | 433 | 137 |
| **2** | 97% | 449 | 151 |

**h) UV/Vis- und Photolumineszenzspektren der Atropisomeren von A1**

Von den Atropisomeren von **A1** (Atropisomer **1** mit 92 % Atropisomerenüberschuss und Atropisomer **2** mit 98 % Atropisomerenüberschuss) wurden die UV/Vis- und die Photolumineszenzspektren im Film bestimmt. Die Ergebnisse sind in Figur 1 gezeigt. Es fällt auf, dass, obwohl die UV/Vis-Spektren keine starken Unterschiede aufweisen, sich die Photolumineszenzspektren erheblich voneinander unterscheiden. So zeigt das Atropisomer **2** in der Photolumineszenz eine strukturierte Emissionsbande, während das Atropisomer **1** eine breite, kaum strukturierte Emissionsbande aufweist, die außerdem deutlich bathochrom verschoben ist.

**Beispiel 2: 9,10-Bis(2-formylphenyl)-anthracen**

**a) Synthese des Atropisomerengemischs:**

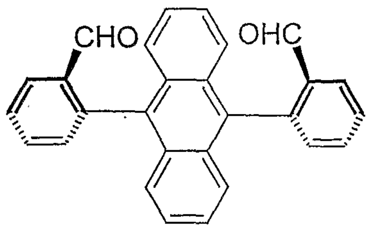

syn-Form

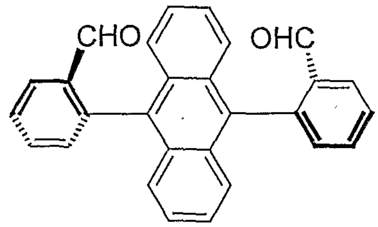

anti-Form

Eine gut gerührte, entgaste Suspension von 33.6 g (100 mmol) 9,10-Dibromanthracen, 45.0 g (300 mmol), 2-Formylbenzolboronsäure und 55.1 g (520 mmol) Natriumcarbonat in einem Gemisch aus 500 ml Toluol, 150 ml Ethanol und 400 ml Wasser wurde mit 2.3 g (2 mmol) Tetrakis-triphenylphosphinopalladium(0) versetzt und 48 h unter Rückfluss erhitzt. Nach Erkalten wurden 500 ml Ethylacetat zugesetzt, die org. Phase wurde abgetrennt, zweimal mit 500 ml Wasser gewaschen, über Magnesiumsulfat getrocknet und dann zur Trockene eingeengt. Der Rückstand wurde in 500 ml Dichlormethan gelöst, über Kieselgel filtriert und erneut zur Trockene eingeengt, in 100 ml Ethanol aufgenommen, unter Rückfluss ausgekocht, nach Erkalten abgesaugt und dann mit etwas Ethanol gewaschen. Die Ausbeute an Rohprodukt betrug 36.7 g (95 mmol), 95.0 % der Theorie.

**b) Bestimmung des Atropisomerenverhältnisses des Rohprodukts**

***Mittels HPLC:***

2 mg des oben beschriebenen Rohprodukts wurden in 10 ml THF gelöst. 5 µl dieser Lösung wurden unter Verwendung eines Agilent LC 1100 HPLC auf einer Zorbax SB-C18 (4.5 x 75 mm, 3.5 Mikron) bei 40 °C und einer Flussrate des Eluenten (81 % Methanol / 9 % THF / 10 % Wasser) von 1 ml/min getrennt.

Die Retentionszeiten [min] und Flächen-% der Atropisomeren betrugen:

| | | |
|---|---|---|
| Atropisomer **1:** | 13.53 min | ca. 28 Flächen-% |
| Atropisomer **2:** | 21.01 min | ca. 72 Flächen-% |

Dies entspricht einem Atropisomerenüberschuss von ca. 44 %. Die UV/Vis-Spektren beider Atropisomeren - entnommen aus den HPLC-Peaks - sind nahezu identisch.

***Mittels $^1$H-NMR-Spektroskopie:***

Die $^1$H-NMR-Spektren wurden auf einem DMX-500 MHz Spektrometer der Fa. Bruker aufgenommen.

Das $^1$H-NMR-Spektrum des oben beschriebenen Atropisomerengemischs ist, bedingt durch die weitgehende Überlappung der Signale der Atropisomere 1 und 2, komplex; jedoch kann das relative molare Verhältnis der Atropisomeren aus zwei ausreichend separierten Singulets, die den Formyl-Protonen zuzuordnen sind, bestimmt werden:

| | | |
|---|---|---|
| Atropisomer **1:** | δ (Formyl-Proton): 9.42 ppm (s); | ca. 30 % |
| Atropisomer **2:** | δ (Formyl-Proton): 9.38 ppm (s); | ca. 70 % |

**c) Präparative Trennung der Atropisomeren**

Die präparative Trennung erfolgte säulenchromatographisch an Kieselgel, Laufmittel n-Hexan : Ethylacetat 5:1 (v:v).

| | |
|---|---|
| Einsatz: | 3.0 g des Rohproduktes |
| Ausbeute: | 0.8 g Atropisomer 1 |
| | 2.0 g Atropisomer 2 |

Atropisomer 1: $^1$H-NMR ($CDCl_3$): $\delta$ [ppm] = 9.42 (s, 2H, CHO), 8.26 (d, 2H), 7.86 (dd, 2H), 7.74 (d, 2H), 7.52 (m, 6H), 7.39 (m, 4H).
Atropisomer 2: $^1$H-NMR ($CDCl_3$): $\delta$ [ppm] = 9.38 (s, 2H, CHO), 8.27 (d, 2H), 7.84 (dd, 2H), 7.74 (d, 2H), 7.52 (m, 6H), 7.39 (m, 4H).

**Beispiel 3: 9,10-Bis(2-methoxyphenyl)-anthracen**

**a) Synthese des Atropisomerengemischs:**

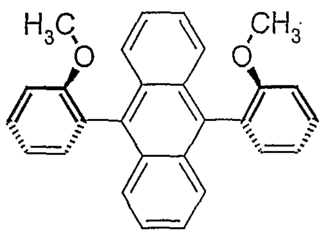

syn-Form

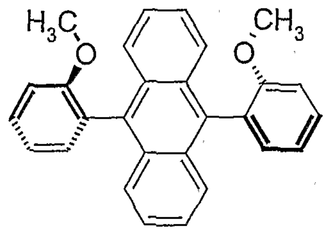

anti-Form

Synthese analog Beispiel 2. Anstelle von 2-Formylbenzolboronsäure wurden 45.6 g (300 mmol) 2-Methoxybenzolboronsäure eingesetzt.
Die Ausbeute an Rohprodukt betrug 31.0 g (79 mmol), 79.3 % der Theorie.

**b) Bestimmung des Atropisomerenverhältnisses des Rohprodukts**

***Mittels HPLC:***

2 mg des oben beschriebenen Rohprodukts wurden in 10 ml THF gelöst. 5 $\mu$l dieser Lösung wurden unter Verwendung eines Agilent LC 1100 HPLC auf einer Zorbax SB-C18 (4.5 x 75 mm, 3.5 Mikron) bei 40 °C und einer Flussrate des Eluenten (76.5 % Methanol / 8.5 % THF / 15 % Wasser) von 1 ml/min getrennt.
Die Retentionszeiten [min] und Flächen-% der Atropisomeren betrugen:

| | | |
|---|---|---|
| Atropisomer **1:** | 4.78 min | ca. 48 Flächen-% |
| Atropisomer **2:** | 7.09 min | ca. 52 Flächen-% |

Dies entspricht einem Atropisomerenüberschuss von ca. 4 %. Die UV/Vis-Spektren beider Atropisomeren - entnommen aus den HPLC-Peaks - sind nahezu identisch.

***Mittels $^1$H-NMR-Spektroskopie:***

Die $^1$H-NMR-Spektren wurden auf einem DMX-500 MHz Spektrometer der Fa. Bruker aufgenommen.
Das $^1$H-NMR-Spektrum des oben beschriebenen Atropisomerengemischs ist, bedingt durch die weitgehende Überlappung der Signale der Atropisomere 1 und 2, komplex; jedoch kann das relative molare Verhältnis der Atropisomeren aus zwei ausreichend separierten Singulets, die den Methyl-Protonen zuzuordnen sind, bestimmt werden:

| | | |
|---|---|---|
| Atropisomer **1:** | $\delta$ (Methyl-Proton): 3.66 ppm (s); | ca. 49 % |
| Atropisomer **2:** | $\delta$ (Methyl-Proton): 3.64 ppm (s); | ca. 51 % |

**c) Präparative Trennung der Atropisomeren**

Die präparative Trennung erfolgte säulenchromatographisch an Kieselgel, Laufmittel n-Hexan : Ethylacetat 10:1 (v:v).

| | |
|---|---|
| Einsatz: | 3.0 g des Rohproduktes |
| Ausbeute: | 1.4 g Atropisomer 1 |
| | 1.3 g Atropisomer 2 |

Atropisomer 1: $^1$H-NMR ($CDCl_3$): $\delta$ [ppm] = 7.63 (AA'BB', 4H, Anthracen), 7.54 (d, 2H), 7.35 (d, 2H), 7.30 (AA'BB', 4H, Anthracen), 7.20-7.16 (m, 2H), 3.66 (s, 3H, $CH_3$).
Atropisomer 2: $^1$H-NMR ($CDCl_3$): $\delta$ [ppm] = 7.63 (AA'BB', 4H, Anthracen), 7.55 (d, 2H), 7.36 (d, 2H), 7.30 (AA'BB', 4H, Anthracen), 7.20-7.16 (m, 2H), 3.648 (s, 3H, $CH_3$).

**Beispiel 4: 9,10-Bis[2-(methylthio)phenyl]-anthracen**

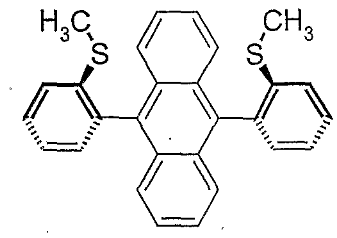

syn-Form

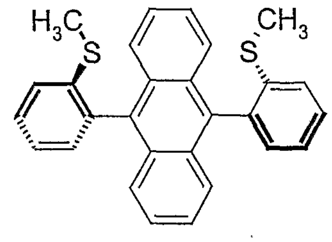

anti-Form

Synthese analog Beispiel 2. Anstelle von 2-Formylbenzolboronsäure wurden 50.4 g (300 mmol) 2-(Methylthio)phenylboronsäure eingesetzt.
Die Ausbeute an Rohprodukt betrug 27.1 g (64 mmol), 64.3 % der Theorie.
Da mit Hilfe von $^1$H-NMR-Spektroskopie und HPLC nur ein Atropisomer aufgefunden wurde, wurde dieses für die weiteren Untersuchungen durch wiederholte Umkristallisation aus DMSO (4 ml / g) gereinigt. Die Ausbeute bei einer Reinheit von 99.8 % betrug 16.6 g (39 mmol), 39.3 % der Theorie. Die Mutterlauge enthielt eine Mischung der Atropisomeren, die nicht weiter untersucht bzw. getrennt wurde.

**b) Bestimmung des Atropisomerenverhältnisses des Rohprodukts**

***Mittels HPLC:***

2 mg des oben beschriebenen Rohprodukts wurden in 10 ml THF gelöst. 5 $\mu$l dieser Lösung wurden unter Verwendung eines Agilent LC 1100 HPLC auf einer Zorbax SB-C18 (4.5 x 75 mm, 3.5 Mikron) bei 40 °C und einer Flussrate des Eluenten (72 % Methanol / 8 % THF / 20 % Wasser) von 1 ml/min getrennt.
Es konnte nur ein Atropisomer aufgefunden werden, die Retentionszeiten [min] und Flächen-% der Atropisomeren betrug:

Atropisomer **1:** 6.48 min 100 Flächen-%

**c) $^1$H-NMR-Spektroskopie:**

$^1$H-NMR (Benzol-d6): $\delta$ [ppm] = 7.84 (AA'BB'4H, Anthracen), 7.40-7.26 (m, 4H), 7.16-7.10 (m, 16H), 1.72 (s, 6H).

**Beispiel 5: Herstellung von OLEDs enthaltend Anthracen-Derivate A1 und deren Eigenschaften**

Die Herstellung von OLEDs erfolgte nach einem allgemeinen Verfahren gemäß WO 04/058911, das im Einzelfall

auf die jeweiligen Gegebenheiten (z. B. Schichtdickenvariation, um optimale Effizienz bzw. Farbe zu erreichen) angepasst wurde. Als Matrixmaterial wurde das Anthracen-Derivat **A1** gemäß Beispiel 1 verwendet. Dabei wurden sowohl die isolierten Atropisomere wie auch das Atropisomerengemisch verwendet.

Analog dem o. g. allgemeinen Verfahren wurden OLEDs mit folgendem Aufbau erzeugt:

| | |
|---|---|
| Lochinjektionsschicht (HIL). | 20 nm PEDOT (aus Wasser aufgeschleudert; bezogen von H. C. Starck, Goslar, Deutschland; Poly(3,4-ethylendioxy-2,5-thiophen) |
| Lochtransportschicht (HTM) | 20 nm NaphDATA (aufgedampft; bezogen von SynTec, Wolfen, Deutschland; 4,4', 4"-Tris(N-1-naphthyl-N-phenyl-amino)-triphenylamin) |
| Lochtransportschicht (HTM) | 20 nm S-TAD (aufgedampft; hergestellt nach WO 99/12888; 2,2',7,7'-Tetrakis (diphenylamino)-spiro-9,9'-bifluoren) |
| Emissionschicht (EML) | 40 nm **A1** (Atropisomer **1,** Atropisomer **2** oder Atropisomerengemisch im Massenverhältnis 1:1, vorgemischt aus den Atropisomeren **1** bzw. **2**), dotiert mit 5 Gew.-% Dotand **D1** |
| Elektronenleiter (ETL) | 20 nm $Alq_3$ (Tris(chinolinato)aluminium(III) |
| Elektroneninjektionsschicht | 1 nm LiF |
| Kathode | 100 nm Al. |

Diese noch nicht optimierten OLEDs wurden standardmäßig charakterisiert; hierfür wurden die Elektrolumineszenzspektren, die photometrische Effizienz (gemessen in cd/A), die Leistungseffizienz (gemessen in lm/W) in Abhängigkeit der Helligkeit, berechnet aus Strom-Spannungs-Helligkeit-Kennlinien (IUL-Kennlinien), und die Lebensdauer bestimmt. Als Lebensdauer wird die Zeit definiert, nach der die Anfangshelligkeit der OLED, ausgehend von einer bestimmten Helligkeit, unter Konstanthaltung des zugehörigen Stromes auf die Hälfte gesunken ist.

Zur besseren Übersichtlichkeit ist die Strukturformel des verwendeten Dotanden **D1** im Folgenden dargestellt:

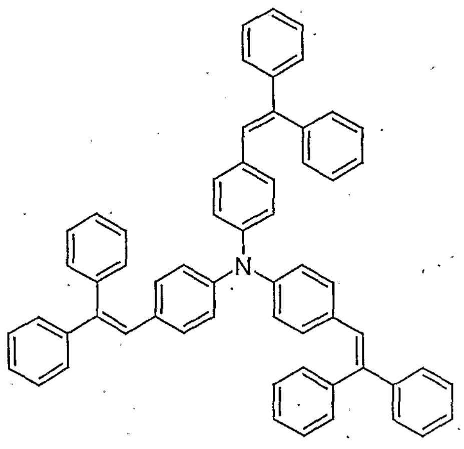

Dotand **D1**

**Stromdichte in Abhängigkeit der Spannung:**

Figur 2 zeigt die Stromdichte-Spannungs-Kurven der Atropisomeren **1** und **2,** sowie des Atropisomerengemischs im angegebenen Einschichtaufbau, Schichtaufbau: ITO / PEDOT 20 nm **/ A1** 40 nm / Ba 4 nm / Al 100 nm.

Dabei wurden zum einen die Atropisomeren **1** und **2,** zum anderen ein Gemisch der Atropisomeren **1** und **2,** erhalten durch inniges Mischen gleicher Gewichtsteile der Atropisomeren **1** und **2** (nachfolgend Atropisomerengemisch genannt) eingesetzt. Atropisomer **1** und **2** von **A1** zeigen eine deutlich geringere Einsatzspannung als das Atropisomerengemisch. So wird z. B. für die Atropisomeren **1** und **2** ein Strom von 10 mA bei Spannungen von etwa 6.0 V erreicht, für das Atropisomerengemisch von **A1** fließt dieser Strom erst bei 7.3 V.

**Effizienz und Lebensdauer:**

Figur 3 zeigt die photometrische Effizienz in cd/A (oberes Kurvenbündel) und Leistungseffizienz in lm/W (unteres Kurvenbündel) als Funktion der Helligkeit der Atropisomeren **1** und **2** sowie des Atropisomerengemischs (1:1 Gewichtsteile der Atropisomeren **1** und **2**) in Devices mit folgendem Schichtaufbau: ITO/ PEDOT 20 nm / NaphDATA 20 nm / S-TAD 20 nm / A1 dotiert mit 5 % Dotand **D1** 40 nm / $Alq_3$ 20 nm / LiF 1 nm / Al 100 nm. Die Aufdampftemperatur des Atropisomeren **1** betrug T = 172 °C, die des Atropisomeren 2 betrug T = 197 °C bei einem Kammerdruck von ca. 5 x $10^{-6}$ mbar und einer Aufdampfrate von ca. 4 Å/s. Die Farbkoordinaten betrugen jeweils CIE: x = 0.17, y = 0.31. Devices enthaltend das Atropisomerengemisch zeigen deutlich schlechtere Leistungsdaten als die der reinen Antropisomeren, wobei hier wiederum das Atropisomere **1** bessere Leistungsdaten als das Atropisomere **2** zeigt.

Ähnliche Verhältnisse können auch den Helligkeits-Zeit-Kurven (Figur 4) entnommen werden. Die Lebensdauer von Devices enthaltend das Atropisomerengemisch ist deutlich geringer als die der isolierten Antropisomeren **1** und **2,** wobei hier wiederum das Atropisomere **1** eine bessere Lebensdauer zeigt.

**Beispiel 6: OLED-Charakterisierung in Abhängigkeit der Aufdampfdauer**

Figur 5 zeigt die photometrische Effizienz in cd/A (oberes Kurvenbündel) und Leistungseffizienz in Im/W (unteres Kurvenbündel) als Funktion der Helligkeit von Devices, die ausgehend von einem Atropisomerengemisch (1:1 Gewichtsteile der Atropisomeren **1** und **2**) von **A1** zu Beginn der Devicepräparation (Kurven 1) und zum Ende, nachdem etwa 90 Gew.-% des eingesetzten Atropisomerengemisch verdampft waren, der Devicepräparation (Kurven 2) erhalten wurden. Schichtaufbau: ITO / PEDOT 20 nm / NaphDATA 20 nm / S-TAD 20 nm / **A1** dotiert mit 5 % Dotand **D1** 40 nm / $Alq_3$ 20 nm / LiF 1 nm / Al 100 nm. Die Farbkoordinaten betrugen jeweils CIE: x = 0.17, y = 0.31.

Devices, die zu Beginn der Devicepräparation erhalten wurden, d. h. solche; die das Atropisomerengemisch enthalten, zeigen schlechtere Leistungsdaten im Vergleich zu den Devices, die gegen Ende der Devicepräparation erhalten wurden und die einen Atropisomerenüberschuss an Atropisomer **2** von 95 %, bestimmt mittels HPLC, enthalten.

Ähnliche Verhältnisse können auch den Helligkeits-Zeit-Kurven (Figur 6) entnommen werden. Devices, die zu Beginn der Devicepräparation erhalten wurden, d. h. solche, die das Atropisomerengemisch enthalten, zeigen eine geringere Lebensdauer im Vergleich zu den Devices, die gegen Ende der Devicepräparation erhalten wurden und die einen Atropisomerenüberschuss an Atropisomer **2** von 95 %, bestimmt mittels HPLC, enthalten.

Insgesamt fällt auf, dass im Laufe der Devicepräparation sich die Anteile der Atropisomeren und die physikalischen Eigenschaften der Devices erheblich verändern und dass so keine reproduzierbare Device-Herstellung möglich ist. Dagegen ist mit den isolierten Atropisomeren **1** und **2** eine reproduzierbare Deviceherstellung möglich.

## Patentansprüche

1. Organische Leuchtdiode (OLED), enthaltend Kathode, Anode und mindestens eine emittierende Schicht, welche mindestens eine organische Verbindung als Hostmaterial enthält, die Atropisomerie aufweist und dadurch zur Bildung von Diastereomeren befähigt ist, **dadurch gekennzeichnet, dass** die Verbindung, die Atropisomerie aufweist, eine Verbindung gemäß Formel (1) ist

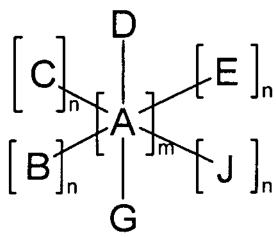

Formel (1)

wobei für die Symbole und Indizes gilt:

A steht für eine 9,10-verknüpfte Anthracen-Einheit, die durch R substituiert oder unsubstituiert sein kann;
B, C, D,
E, G, J ist bei jedem Auftreten gleich oder verschieden ein aromatisches oder heteroaromatisches Ringsystem mit 5 bis 40 aromatischen Ringatomen, das unsubstituiert oder durch einen oder mehrere Reste R substituiert sein kann, mit der Maßgabe, dass in mindestens einer ortho-Position zur Verknüpfung zu A eine Gruppe R gebunden ist, bzw. dass diese Position durch einen Teil des Ringsystems blockiert ist, wenn B, C, D, E, G bzw. J ein kondensiertes aromatisches Ringsystem darstellen;
R ist bei jedem Auftreten gleich oder verschieden F, Cl, Br, I, eine geradkettige Alkyl- oder Alkoxykette mit 1

bis 40 C-Atomen oder eine verzweigte oder cyclische Alkyl- oder Alkoxykette mit 3 bis 40 C-Atomen, die jeweils durch $R^1$ substituiert sein kann, in der auch ein oder mehrere nicht benachbarte C-Atome durch N-$R^1$, O, S, C=O, O-CO-O, CO-O, SO, $SO_2$, P(=O)$R^1$, Si($R^1$)$_2$, -$CR^1$=$CR^1$- oder -C≡C- ersetzt sein können und in der auch ein oder mehrere H-Atome durch F, Cl, Br, I oder CN ersetzt sein können, oder ein aromatisches oder heteroaromatisches Ringsystem mit 5 bis 40 aromatischen Ringatomen, welches auch durch einen oder mehrere Reste $R^1$ substituiert sein kann, oder eine Kombination aus zwei, drei, vier oder fünf dieser Systeme; dabei können zwei oder mehrere Reste R miteinander auch ein weiteres mono- oder polycyclisches, aliphatisches oder aromatisches Ringsystem bilden;

$R^1$ ist bei jedem Auftreten gleich oder verschieden H oder ein aliphatischer oder aromatischer Kohlenwasserstoffrest mit 1 bis 20 C-Atomen;

n ist bei jedem Auftreten gleich oder verschieden 0 oder 1;

m ist bei jedem Auftreten gleich oder verschieden 1, 2, 3, 4 oder 5; und

ein Atropisomerenüberschuss von mindestens 70 % vorliegt und dass die Atropisomerie durch gehinderte Rotation um C-C-Einfachbindungen erzeugt wird.

2. Organische elektronische Vorrichtung gemäß Anspruch 1, **dadurch gekennzeichnet, dass** sie außer der Schicht, die die Verbindung enthält, die Atropisomerie aufweist, noch weitere Schichten enthält.

3. Organische elektronische Vorrichtung gemäß Anspruch 1 oder 2, **dadurch gekennzeichnet, dass** die Aktivierungsenergie für die Rotation um die rotationsgehinderten Einfachbindungen mindestens 80 kJ/mol beträgt.

4. Organische elektronische Vorrichtung gemäß einem oder mehreren der Ansprüche 1 bis 3, **dadurch gekennzeichnet, dass** die Atropisomerie durch gehinderte Rotation um Einfachbindungen zwischen zwei $sp^2$-Zentren erzeugt wird.

5. Organische elektronische Vorrichtung gemäß einem oder mehreren der Ansprüche 1 bis 4, **dadurch gekennzeichnet, dass** die Verbindung, die Atropisomerie aufweist, zwei Einfachbindungen mit gehinderter Rotation enthält und das überwiegend vorliegende Atropisomer das syn-Isomer ist.

6. Organische elektronische Vorrichtung gemäß einem oder mehreren der Ansprüche 1 bis 5, **dadurch gekennzeichnet, dass** die Verbindung, die Atropisomerie aufweist, zwei Einfachbindungen mit gehinderter Rotation enthält und das überwiegend vorliegende Atropisomer das anti-Isomer ist.

7. Organische elektronische Vorrichtung gemäß einem oder mehreren der Ansprüche 1 bis 6, **dadurch gekennzeichnet, dass** die Verbindung, die Atropisomerie aufweist, drei Einfachbindungen mit gehinderter Rotation enthält, wobei die Einfachbindungen, um die Atropisomerie vorliegt, linear oder verzweigt angeordnet sind.

8. Organische elektronische Vorrichtung gemäß einem oder mehreren der Ansprüche 1 bis 7, **dadurch gekennzeichnet, dass** die Verbindung, die Atropisomerie aufweist, vier Einfachbindungen mit gehinderter Rotation enthält, wobei die Einfachbindungen, um die Atropisomerie vorliegt, linear oder verzweigt angeordnet sind.

9. Atropisomerengemisch, das zur Bildung von Diastereomeren befähigt ist, gemäß Formel (1),

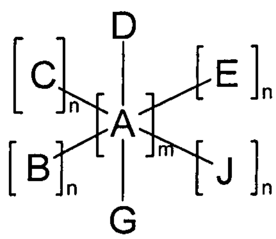

Formel (1)

wobei R und $R^1$ dieselbe Bedeutung haben, wie in Anspruch 10 beschrieben, und für die weiteren verwendeten Symbole gilt:

A ist 9,10-Anthracen, das durch R substituiert oder unsubstituiert ist;

D, G ist bei jedem Auftreten gleich oder verschieden ein aromatisches oder heteroaromatisches Ringsystem mit 5 bis 40 aromatischen Ringatomen, das unsubstituiert oder durch R substituiert sein kann, mit der Maßgabe, dass in ortho-Position zur Verknüpfung zu A mindestens ein aromatischer Rest R vorhanden ist, der auch an die entsprechende Einheit B bis J ankondensiert sein kann;
m ist 1;
n ist 0;

**dadurch gekennzeichnet, dass** ein Atropisomerenüberschuss von mindestens 70 % vorliegt und die Atropisomerie durch gehinderte Rotation um C-C-Einfachbindungen erzeugt wird.

**10.** Verbindungen gemäß Anspruch 9, **dadurch gekennzeichnet, dass** D und G unabhängig voneinander ausgewählt sind aus der Gruppe bestehend aus durch R substituiertem oder unsubstituiertem 1-Naphthyl, ortho-Biphenyl oder 1-Anthryl.

**11.** Konjugierte, teilkonjugierte oder nicht-konjugierte Polymere, Oligomere oder Dendrimere enthaltend Wiederholeinheiten, die Atropisomere bilden und dadurch zur Bildung von Diastereomeren befähigt sind, **dadurch gekennzeichnet, dass** ein Atropisomerenüberschuss von mindestens 70 % verwendet wird.

**12.** Polymere gemäß Anspruch 11, **dadurch gekennzeichnet, dass** es sich um Polyfluorene, Poly-spirobifluorene, Poly-para-phenylene, Polydihydrophenanthrene, Poly-phenanthrene, Poly-indenofluorene, Poly-carbazole, Poly-anthracene, Polynaphthaline oder Polythiophene handelt, aber auch Polymere mit mehreren dieser Einheiten oder Homopolymere der Verbindungen, die Atropisomerie aufweisen.

**13.** Polymere, Oligomere oder Dendrimere gemäß Anspruch 11 und/oder 12, **dadurch gekennzeichnet, dass** das im Polymer im Überschuss vorliegende Atropisomer dasjenige ist, welches besser löslich ist.

## Claims

**1.** Organic light-emitting diode (OLED) comprising cathode, anode and at least one emitting layer which comprises as host material at least one organic compound which has atropisomerism and is thus capable of the formation of diastereomers, **characterised in that** the compound that has atropisomerism is a compound of the formula (1)

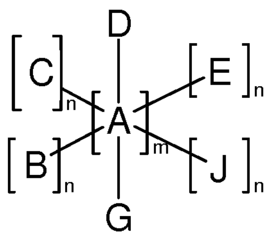

formula (1)

where the following applies to the symbols and indices:

A stands for a 9,10-linked anthracene unit, which may be substituted by R or unsubstituted;
B, C, D,
E, G, J are on each occurrence, identically or differently, an aromatic or heteroaromatic ring system having 5 to 40 aromatic ring atoms, which may be unsubstituted or substituted by one or more radicals R, with the proviso that a group R is bonded in at least one ortho-position to the link to A, or that this position is blocked by a part of the ring system if B, C, D, E, G or J represents a condensed aromatic ring system;
R is on each occurrence, identically or differently, F, Cl, Br, I, a straight-chain alkyl or alkoxy chain having 1 to 40 C atoms or a branched or cyclic alkyl or alkoxy chain having 3 to 40 C atoms, which may in each case be substituted by $R^1$, in which, in addition, one or more non-adjacent C atoms may be replaced by $N-R^1$, O, S, C=O, O-CO-O, CO-O, SO, $SO_2$, $P(=O)R^1$, $Si(R^1)_2$, $-CR^1=CR^1-$ or $-C\equiv C-$ and in which, in addition, one or more H atoms may be replaced by F, Cl, Br, I or CN, or an aromatic or heteroaromatic ring system having 5 to 40 aromatic ring atoms, which may in addition be substituted by one or more radicals $R^1$, or a combination of two,

three, four or five of these systems; two or more radicals R here may also form a further mono- or polycyclic, aliphatic or aromatic ring system with one another;
$R^1$ is on each occurrence, identically or differently, H or an aliphatic or aromatic hydrocarbon radical having 1 to 20 C atoms;
n is on each occurrence, identically or differently, 0 or 1;
m is on each occurrence, identically or differently, 1, 2, 3, 4 or 5; and
an atropisomeric excess of at least 70% is present and the atropisomerism is generated by hindered rotation about C-C single bonds.

2. Organic electronic device according to Claim 1, **characterised in that** it also comprises further layers in addition to the layer that comprises the compound which has atropisomerism.

3. Organic electronic device according to Claim 1 or 2, **characterised in that** the activation energy for the rotation about the rotationally hindered single bonds is at least 80 kJ/mol.

4. Organic electronic device according to one or more of Claims 1 to 3, **characterised in that** the atropisomerism is produced by hindered rotation about single bonds between two $sp^2$ centres.

5. Organic electronic device according to one or more of Claims 1 to 4, **characterised in that** the compound that has atropisomerism contains two single bonds with hindered rotation, and the atropisomer predominantly present is the syn isomer.

6. Organic electronic device according to one or more of Claims 1 to 5, **characterised in that** the compound that has atropisomerism contains two single bonds with hindered rotation, and the atropisomer predominantly present is the anti isomer.

7. Organic electronic device according to one or more of Claims 1 to 6, **characterised in that** the compound that has atropisomerism contains three single bonds with hindered rotation, where the single bonds about which atropisomerism is present are in a linear or branched arrangement.

8. Organic electronic device according to one or more of Claims 1 to 7, **characterised in that** the compound that has atropisomerism contains four single bonds with hindered rotation, where the single bonds about which atropisomerism is present are in a linear or branched arrangement.

9. Atropisomer mixture which is capable of the formation of diastereomers, of the formula (1)

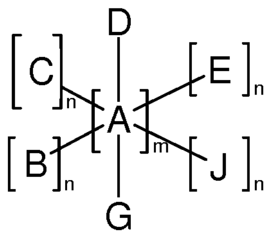

formula (1)

where R and $R^1$ have the same meaning as described in Claim 1, and the following applies to the other symbols used:

A is 9,10-anthracene, which is substituted by R or unsubstituted;
D, G are on each occurrence, identically or differently, an aromatic or hetero-aromatic ring system having 5 to 40 aromatic ring atoms, which may be unsubstituted or substituted by R, with the proviso that at least one aromatic radical R, which may also be condensed onto the corresponding unit B to J, is present in the ortho-position to the link to A;
m is 1;
n is 0;

**characterised in that** an atropisomeric excess of at least 70% is present and the atropisomerism is generated by

hindered rotation about C-C single bonds.

**10.** Compounds according to Claim 9, **characterised in that** D and G are selected, independently of one another, from the group consisting of R-substituted or unsubstituted 1-naphthyl, ortho-biphenyl and 1-anthryl.

**11.** Conjugated, partially conjugated or non-conjugated polymers, oligomers or dendrimers containing recurring units which form atropisomers and are thus capable of the formation of diastereomers, **characterised in that** an atropisomeric excess of at least 70% is used.

**12.** Polymers according to Claim 11, **characterised in that** they are polyfluorenes, polyspirobifluorenes, poly-paraphenylenes, polydihydrophenanthrenes, polyphenanthrenes, polyindenofluorenes, polycarbazoles, polyanthracenes, polynaphthalenes or polythiophenes, but also polymers having a plurality of these units or homopolymers of the compounds that have atropisomerism.

**13.** Polymers, oligomers or dendrimers according to Claim 11 and/or 12, **characterised in that** the atropisomer present in excess in the polymer is the one that has better solubility.

## Revendications

**1.** Diode émettrice de lumière/électroluminescente organique (OLED) comprenant une cathode, une anode et au moins une couche d'émission qui comprend, en tant que matériau hôte, au moins un composé organique qui présente un atropisomérisme et dispose par voie de conséquence de la capacité de formation de diastéréomères, **caractérisée en ce que** le composé qui présente un atropisomérisme est un composé de la formule (1) :

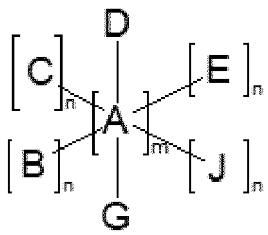

formule (1)

dans laquelle ce qui suit s'applique aux symboles et indices :

A représente une unité d'anthracène 9,10-liée, laquelle peut être substituée par R ou non substituée ;
B, C, D,
E, G, J sont pour chaque occurrence, de manière identique ou différente, un système de cycle aromatique ou hétéroaromatique qui comporte de 5 à 40 atomes de cycle aromatique, lequel peut être non substitué ou substitué par un radical ou par plusieurs radicaux R, étant entendu qu'un groupe R est lié au niveau d'au moins une position ortho sur la liaison sur A, ou que cette position est bloquée par une partie du système de cycle si B, C, D, E, G ou J représente un système de cycle aromatique condensé ;
R est pour chaque occurrence, de manière identique ou différente, F, Cl, Br, I, une chaîne alkyle ou alcoxy en chaîne droite qui comporte de 1 à 40 atome(s) de C ou une chaîne alkyle ou alcoxy ramifiée ou cyclique qui comporte de 3 à 40 atomes de C, laquelle peut dans chaque cas être substituée par $R^1$, où, en outre, un ou plusieurs atome(s) de C non adjacents peut/peuvent être remplacé(s) par N-$R^1$, O, S, C=O, O-CO-O, CO-O, SO, $SO_2$, P(=O)$R^1$, Si$(R^1)_2$, -$CR^1$=$CR^1$- ou -C≡C- et où, en outre, un ou plusieurs atome(s) de H peut/peuvent être remplacé(s) par F, Cl, Br, I ou CN, ou un système de cycle aromatique ou hétéroaromatique qui comporte de 5 à 40 atomes de cycle aromatique, lequel peut en outre être substitué par un radical ou par plusieurs radicaux $R^1$, ou une combinaison de deux, trois, quatre ou cinq de ces systèmes ; deux radicaux R ou plus peuvent ici également former un autre système de cycle mono- ou polycyclique, aliphatique ou aromatique l'un avec l'autre ou les uns avec les autres ;
$R^1$ est pour chaque occurrence, de manière identique ou différente, H ou un radical hydrocarbone aliphatique ou aromatique qui comporte de 1 à 20 atome(s) de C ;
n est pour chaque occurrence, de manière identique ou différente, 0 ou 1 ;

m est pour chaque occurrence, de manière identique ou différente, 1, 2, 3, 4 ou 5 ; et

un excès atropisomérique d'au moins 70% est présent et l'atropisomérisme est généré par une rotation entravée autour de liaisons simples C-C.

**2.** Dispositif électronique organique selon la revendication 1, **caractérisé en ce qu'**il comprend également d'autres couches en plus de la couche qui comprend le composé qui présente un atropisomérisme.

**3.** Dispositif électronique organique selon la revendication 1 ou 2, **caractérisé en ce que** l'énergie d'activation pour la rotation autour des liaisons simples à rotation entravée est d'au moins 80 kJ/mol.

**4.** Dispositif électronique organique selon une ou plusieurs des revendications 1 à 3, **caractérisé en ce que** l'atropisomérisme est produit par une rotation entravée autour de liaisons simples entre deux centres $sp^2$.

**5.** Dispositif électronique organique selon une ou plusieurs des revendications 1 à 4, **caractérisé en ce que** le composé qui présente l'atropisomérisme contient deux liaisons simples à rotation entravée, et l'atropisomère présent de façon prédominante est le syn-isomère.

**6.** Dispositif électronique organique selon une ou plusieurs des revendications 1 à 5, **caractérisé en ce que** le composé qui présente l'atropisomérisme contient deux liaisons simples à rotation entravée, et l'atropisomère présent de façon prédominante est l'anti-isomère.

**7.** Dispositif électronique organique selon une ou plusieurs des revendications 1 à 6, **caractérisé en ce que** le composé qui présente l'atropisomérisme contient trois liaisons simples à rotation entravée, dans lequel les liaisons simples autour/au voisinage desquelles l'atropisomérisme est présent sont selon un agencement linéaire ou ramifié.

**8.** Dispositif électronique organique selon une ou plusieurs des revendications 1 à 7, **caractérisé en ce que** le composé qui présente l'atropisomérisme contient quatre liaisons simples à rotation entravée, dans lequel les liaisons simples autour/au voisinage desquelles l'atropisomérisme est présent sont selon un agencement linéaire ou ramifié.

**9.** Mélange d'atropisomères qui dispose de la capacité de formation de diastéréomères, de la formule (1) :

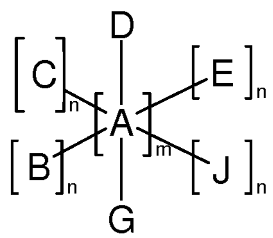

formule (1)

dans laquelle R et $R^1$ présentent la même signification que celle qui a été décrite selon la revendication 1, et ce qui suit s'applique aux autres symboles qui sont utilisés :

A est 9,10-anthracène, lequel est substitué par R ou non substitué ;
D, G sont pour chaque occurrence, de manière identique ou différente, un système de cycle aromatique ou hétéroaromatique qui comporte de 5 à 40 atomes de cycle aromatique, lequel peut être non substitué ou substitué par R, étant entendu qu'au moins un radical aromatique R, qui peut également être condensé sur l'unité correspondante B à J, est présent au niveau de la position ortho sur la liaison sur A ;
m est 1 ;
n est 0 ;

**caractérisé en ce qu'**un excès atropisomérique d'au moins 70% est présent et l'atropisomérisme est généré par une rotation entravée autour des liaisons simples C-C.

**10.** Composés selon la revendication 9, **caractérisés en ce que** D et G sont sélectionnés, de manière indépendante

l'un de l'autre, parmi le groupe qui est constitué par 1-naphthyle, ortho-biphényle et 1-anthryle substitués par R ou non substitués.

**11.** Polymères, oligomères ou dendrimères conjugués, partiellement conjugués ou non conjugués contenant des unités récurrentes qui forment des atropisomères et qui disposent par voie de conséquence de la capacité de formation de diastéréomères, **caractérisés en ce qu'**un excès atropisomérique d'au moins 70% est utilisé.

**12.** Polymères selon la revendication 11, **caractérisés en ce que** ce sont des polyfluorènes, des polyspirobifluorènes, des poly-para-phénylènes, des polydihydrophénanthrènes, des polyphénanthrènes, des polyindénofluorènes, des polycarbazoles, des polyanthracènes, des polynaphtalènes ou des polythiophènes, mais également des polymères qui comportent une pluralité de ces unités ou des homopolymères des composés qui présentent de l'atropisomérisme.

**13.** Polymères, oligomères ou dendrimères selon la revendication 11 et/ou 12, **caractérisés en ce que** l'atropisomère présent en excès dans le polymère est celui qui présente une solubilité meilleure.

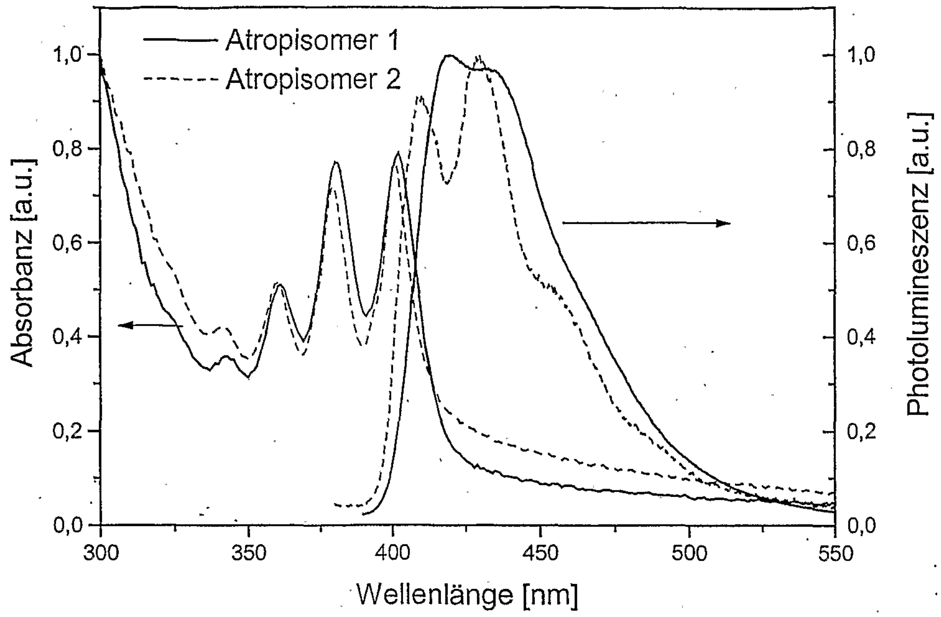


**Figur 1:** UV/Vis- und Photolumineszenzspektren der Atropisomeren von **A1**

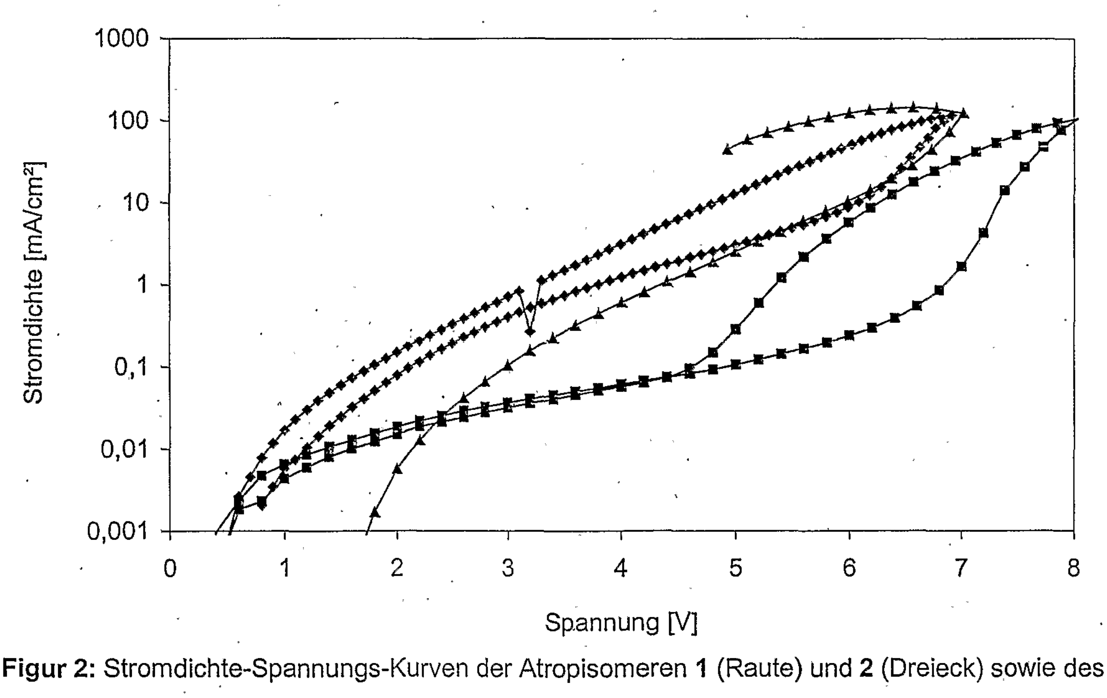


**Figur 2:** Stromdichte-Spannungs-Kurven der Atropisomeren **1** (Raute) und **2** (Dreieck) sowie des Atropisomerengemischs (Quadrat) in Devices mit folgendem Schichtaufbau: ITO / PEDOT 20 nm / **A1** 40 nm / Ba 4 nm / Al 100 nm.

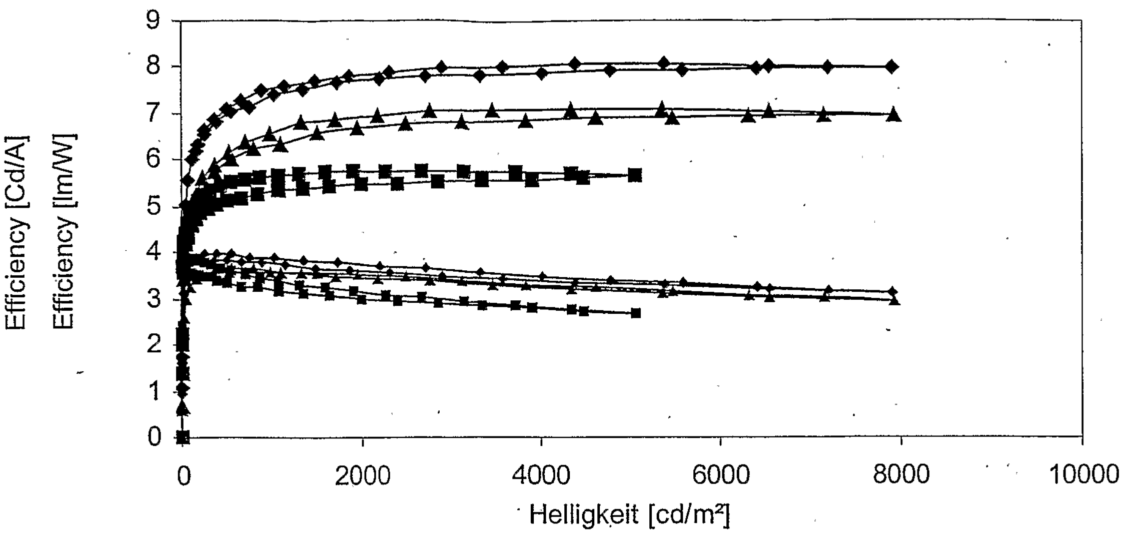


**Figur 3:** Photometrische Effizienz in cd/A (oberes Kurvenbündel) und Leistungseffizienz in lm/W (unteres Kurvenbündel) als Funktion der Helligkeit der Atropisomeren **1** (Raute) und **2** (Dreieck) sowie des Atropisomerengemischs (Quadrat) von **A1** in Devices mit folgendem Schichtaufbau: ITO / PEDOT 20 nm / NaphDATA 20 nm / S-TAD 20 nm / **A1** dotiert mit 5 % Dotand **D1** 40 nm / $Alq_3$ 20 nm / LiF 1 nm / Al 100 nm; Farbkoordinaten CIE: x = 0.17, y = 0.31.

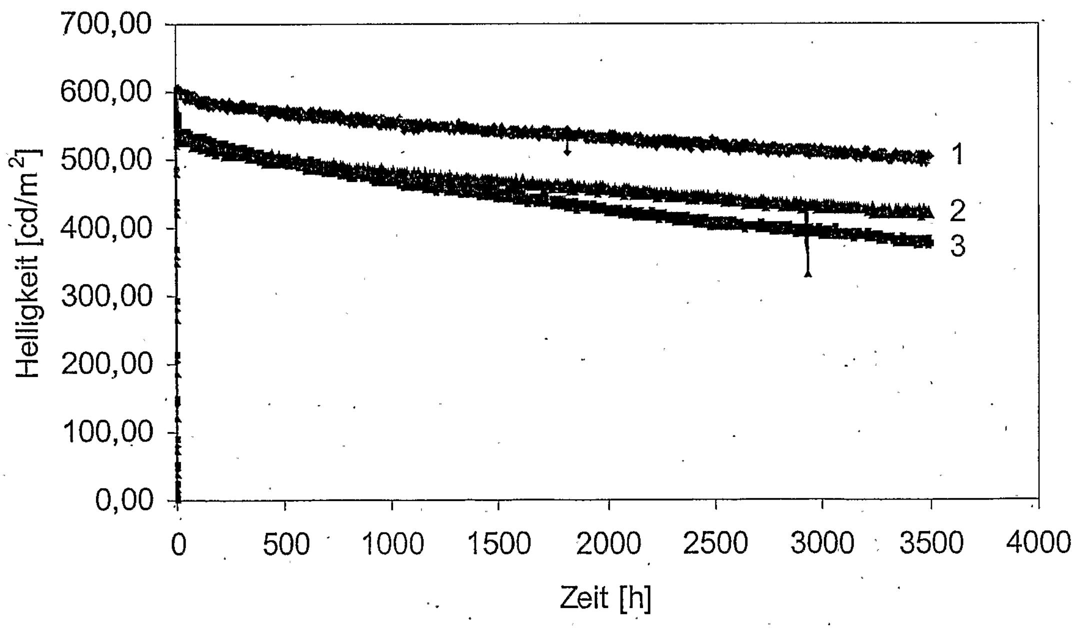


**Figur 4:** Lebensdauerkurven der Devices der Atropisomeren **1** (Kurve 1) und **2** (Kurve 2) sowie des Atropisomerengemischs (Kurve 3) von **A1** mit folgendem Schichtaufbau: ITO / PEDOT 20 nm / NaphDATA 20 nm / S-TAD 20 nm / **A1** dotiert mit 5 % Dotand **D1** 40 nm / $Alq_3$ 20 nm / LiF 1 nm / Al 100 nm; Farbkoordinaten CIE: x = 0.17, y = 0.31.

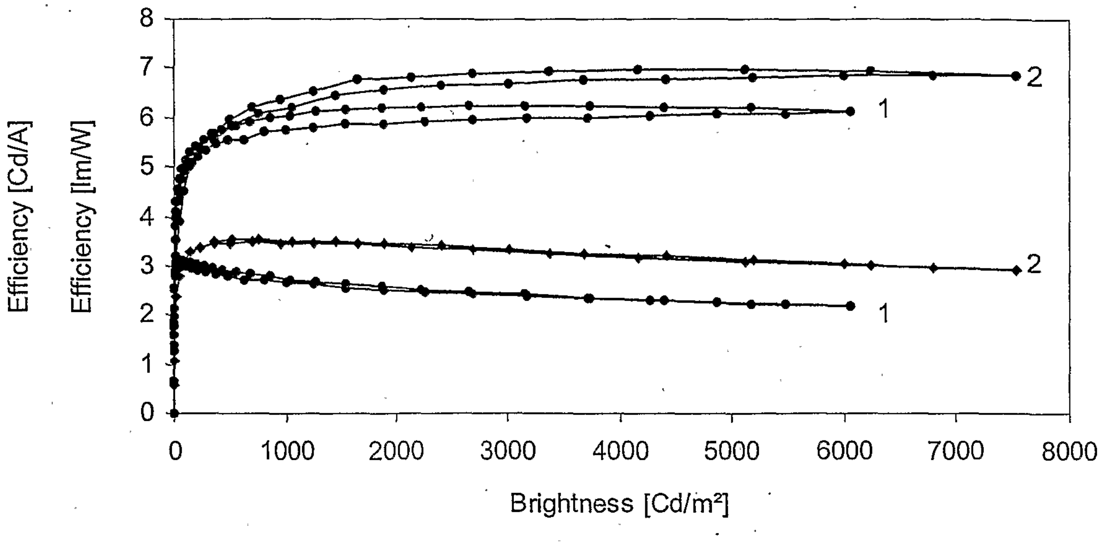


**Figur 5:** Photometrische Effizienz in Cd/A (oberes Kurvenbündel) und Leistungseffizienz in lm/W (unteres Kurvenbündel) als Funktion der Helligkeit von Devicen mit dem unten angegeben Schichtaufbau präpariert zu Beginn einer Devicepräparation (Kurven 1) und zum Ende (Kurven 2) derselben Devicepräparation; Schichtaufbau: ITO / PEDOT 20 nm / NaphDATA 20 nm / S-TAD 20 nm / **A1** dotiert mit 5 % Dotand **D1** 40 nm / $Alq_3$ 20 nm / LiF 1 nm / Al 100 nm; Farbkoordinaten CIE: x = 0.17, y = 0.31.

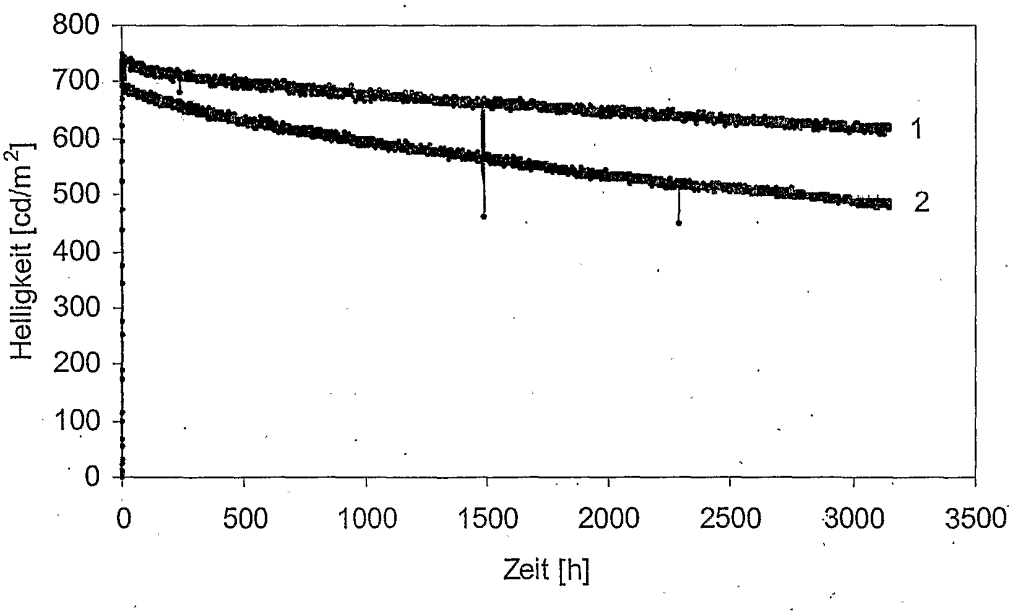


**Figur 6:** Helligkeit als Funktion der Zeit von Devices mit dem unten angegeben Schichtaufbau präpariert zu Beginn einer Devicepräparation (Kurve 1) und zum Ende (Kurve 2) derselben Devicepräparation; Schichtaufbau: ITO / PEDOT 20 nm / NaphDATA 20 nm / S-TAD 20 nm / **A1** dotiert mit 5 % Dotand **D1** 40 nm / $Alq_3$ 20 nm / LiF 1 nm / Al 100 nm; Farbkoordinaten CIE: x = 0.17, y = 0.31.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 5935721 A
- WO 01076323 A
- WO 01021729 A
- WO 04013073 A
- WO 04018588 A
- WO 03087023 A
- WO 04018587 A
- WO 04016575 A
- US 20040161633 A
- WO 03095445 A
- CN 1362464
- US 5929239 A
- EP 0952200 A
- US 5886183 A
- EP 842208 A
- WO 0022026 A
- EP 707020 A
- EP 894107 A
- WO 9218552 A
- WO 05014689 A
- DE 102004020298
- WO 04041901 A
- WO 04113412 A
- EP 1028136 A
- WO 04058911 A
- WO 9912888 A


### In der Beschreibung aufgeführte Nicht-Patentliteratur


- **N.-X. HU et al.** *J. Am. Chem. Soc.,* 1999, vol. 121, 5097
- Römpp Lexikon Chemie. Georg Thieme Verlag, 1999
- **J. GAWRONSKI ; K. KACPRZAK.** *Chirality,* 2002, vol. 14, 689